# EUROPEAN PATENT APPLICATION

(11) **EP 4 750 076 A1**
(43) Date of publication of application: **27.05.2026**
(21) Application number: 25214461.3
(22) Date of filing: 07.11.2025
(51) Int. Cl.: H04N 25/581, H04N 25/59, H04N 25/771, H04N 25/778, H04N 25/585

(54) **IMAGE SENSOR**

(30) Priority: 20.11.2024 KR 20240166075
(71) Applicant: Samsung Electronics Co., Ltd., Suwon-si, Gyeonggi-do 16677 (KR)
(72) Inventor: KIM, Youngchan, 16677 Suwon-si (KR); YOO, Dongsuk, 16677 Suwon-si (KR)
(74) Representative: Marks & Clerk LLP

(57) **Abstract**

An image sensor includes a pixel array including a plurality of pixel groups arranged in a first direction and a second direction intersecting the first direction, wherein each of the plurality of pixel groups includes a plurality of photodiodes and a pixel circuit configured to output a signal corresponding to electric charges generated by at least one of a plurality of photodiodes. The plurality of photodiodes include at least a first primary photodiode and at least a first secondary photodiode. The pixel circuit includes a first floating diffusion node connected to the first primary photodiode by a first primary transfer transistor, a second floating diffusion node connected to the first secondary photodiode by a first secondary transfer transistor, a first switch transistor connected between the first floating diffusion node and the second floating diffusion node, a reset transistor and a gain control transistor connected between a second power node and the first floating diffusion node in series, a capacitor and a second switch transistor connected in series with each other between a first power node and a second floating diffusion node, an amplification transistor having a gate connected to the first floating diffusion node and connected to a third power node, and a select transistor connected between the amplification transistor and a column line.

## Description

### BACKGROUND

Example embodiments of the present disclosure relate to an image sensor.

An image sensor may receive light and may generate an electric signal, and may include a pixel array having a plurality of pixels, and a peripheral circuit for driving a pixel array and generating an image. Each of a plurality of pixel groups may include a plurality of photodiodes and a pixel circuit configured to convert electric charges generated by the plurality of photodiodes into an electric signal. The range of light intensity represented by an image sensor may be defined as a dynamic range. A dynamic range may be improved by including a capacitor in each of the plurality of pixel groups, but sensitivity of the image sensor may be reduced.

### SUMMARY

An example embodiment of the present disclosure is to selectively control sensitivity of a readout operation of reading voltage corresponding to electric charges stored in a capacitor by controlling the number of photodiodes connected to each capacitor of a plurality of pixel groups using a switch transistor during an exposure time period.

According to an example embodiment of the present disclosure, an image sensor includes a pixel array including a plurality of pixel groups, wherein each of the plurality of pixel groups includes a plurality of PD (photodiode) regions arranged in a first direction and a second direction intersecting the first direction, wherein each of the plurality of pixel groups includes a plurality of photodiodes disposed in the plurality of PD regions and a pixel circuit configured to output a signal corresponding to electric charges generated by at least one of the plurality of photodiodes. The plurality of photodiodes include at least a first primary photodiode and at least a first secondary photodiode. The pixel circuit includes a first floating diffusion node connected to the first primary photodiode by a first primary transfer transistor, a second floating diffusion node connected to the first secondary photodiode by a first secondary transfer transistor, a first switch transistor connected between the first floating diffusion node and the second floating diffusion node, a reset transistor and a gain control transistor connected between a second power node and the first floating diffusion node in series, a capacitor and a second switch transistor connected in series with each other between a first power node and a second floating diffusion node, an amplification transistor having a gate connected to the first floating diffusion node and connected to a third power node, and a select transistor connected between the amplification transistor and a column line.

According to an example embodiment of the present disclosure, an image sensor includes a pixel array including a plurality of pixel groups, each of the plurality of pixel groups includes a plurality of PD (photodiode) regions arranged in a first direction and a second direction intersecting the first direction; and a peripheral circuit connected to the plurality of pixel groups by a plurality of row lines and a plurality of column lines, and configured to drive the plurality of pixel groups. Each of the plurality of pixel groups includes at least a first primary photodiode, at least a first secondary photodiode, and a pixel circuit connecting the first primary photodiode and the first secondary photodiode to the peripheral circuit. The pixel circuit includes a capacitor configured to store at least a portion of electric charges generated by the first secondary photodiode during an exposure time period. The peripheral circuit is configured to obtain a first pixel signal and a second pixel signal by executing a first readout operation for each of the plurality of pixel groups after the exposure time period, obtain a third pixel signal corresponding to electric charge stored in the capacitor by executing a second readout operation, and generate image data using the first pixel signal, the second pixel signal, and the third pixel signal. The first pixel signal is a signal output by each of the plurality of pixel groups under a high conversion gain condition, and the second pixel signal is a signal output by each of the plurality of pixel groups under a low conversion gain condition.

According to an example embodiment of the present disclosure, an image sensor includes a plurality of pixel groups, each of the plurality of pixel groups includes a plurality of PD (photodiode) regions arranged in a first direction and a second direction intersecting the first direction; and a peripheral circuit connected to the plurality of pixel groups by a plurality of row lines and a plurality of column lines, and configured to drive the plurality of pixel groups. Each of the plurality of pixel groups includes at least a first primary photodiode, at least a first secondary photodiode, and a pixel circuit connecting the first primary photodiode and the first secondary photodiode to the peripheral circuit. The pixel circuit includes a first floating diffusion node, a first transfer transistor connected between the first floating diffusion node and the first primary photodiode, a first switch transistor connected between the first floating diffusion node and a second floating diffusion node, a second switch transistor and a capacitor connected to the second floating diffusion node and connected to each other in series, and a first secondary transfer transistor connected between the second floating diffusion node and the first secondary photodiode. The capacitor is configured to store at least a portion of electric charges generated by the first secondary photodiode without storing electric charges generated by the first primary photodiode during an exposure time period.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a block diagram illustrating an image sensor according to an example embodiment of the present disclosure;
FIG. 2 is a diagram illustrating a pixel array structure of an image sensor according to an example embodiment of the present disclosure;
FIG. 3 is a diagram illustrating a structure of a pixel group included in an image sensor according to an example embodiment of the present disclosure;
FIG. 4 is a circuit diagram illustrating a pixel group according to an example embodiment of the present disclosure;
FIG. 5 is a diagram illustrating operations of a pixel group according to the example embodiment illustrated in FIG. 4;
FIG. 6 is a diagram illustrating a layout of a pixel group according to the example embodiment illustrated in FIG. 4;
FIG. 7 is a diagram illustrating a layout of a pixel group according to the example embodiment illustrated in FIG. 4;
FIG. 8 is a circuit diagram illustrating a pixel group according to an example embodiment of the present disclosure;
FIG. 9 is a diagram illustrating operations of a pixel group according to the example embodiment illustrated in FIG. 8;
FIG. 10 is a diagram illustrating a layout of a pixel group according to the example embodiment illustrated in FIG. 8;
FIG. 11 is a circuit diagram illustrating a pixel group according to an example embodiment of the present disclosure;
FIG. 12 is a diagram illustrating operations of a pixel group according to the example embodiment illustrated in FIG. 11;
FIG. 13 is a diagram illustrating a layout of a pixel group according to the example embodiment illustrated in FIG. 11;
FIG. 14 is a diagram illustrating a pixel array structure of an image sensor according to an example embodiment of the present disclosure;
FIG. 15 is a diagram illustrating the structure of a pixel group included in an image sensor according to an example embodiment of the present disclosure;
FIG. 16 is a circuit diagram illustrating a pixel group according to an example embodiment of the present disclosure;
FIG. 17 is a diagram illustrating the operation of a pixel group according to the example embodiment illustrated in FIG. 16;
FIG. 18 is a diagram illustrating the layout of a pixel group according to the example embodiment illustrated in FIG. 16;
FIG. 19 is a circuit diagram illustrating a pixel group according to an example embodiment of the present disclosure;
FIG. 20 is a diagram illustrating operations of a pixel group according to the example embodiment illustrated in FIG. 19;
FIG. 21 is a diagram illustrating the layout of a pixel group according to the example embodiment illustrated in FIG. 19;
FIG. 22 is a circuit diagram illustrating a pixel group according to an example embodiment of the present disclosure;
FIG. 23 is a diagram illustrating operations of a pixel group according to the example embodiment illustrated in FIG. 22;
FIG. 24 is a diagram illustrating a layout of a pixel group according to the example embodiment illustrated in FIG. 22;
FIG. 25 is a circuit diagram illustrating a pixel group according to an example embodiment of the present disclosure;
FIG. 26 is a circuit diagram illustrating a pixel group according to an example embodiment of the present disclosure;
FIG. 27 is a diagram illustrating operations of a pixel group according to the example embodiment illustrated in FIG. 25;
FIG. 28 is a diagram illustrating a layout of a pixel group according to the example embodiment illustrated in FIG. 25;
FIG. 29 is a diagram illustrating a pixel array structure of an image sensor according to an example embodiment of the present disclosure;
FIG. 30 is a diagram illustrating a structure of a pixel group included in an image sensor according to an example embodiment of the present disclosure;
FIG. 31 is a circuit diagram illustrating a pixel group according to an example embodiment of the present disclosure;
FIG. 32 is a diagram illustrating operations of a pixel group according to the example embodiment illustrated in FIG. 31; and
FIG. 33 is a diagram illustrating a layout of a pixel group according to the example embodiment illustrated in FIG. 31.

### DETAILED DESCRIPTION

Hereinafter, embodiments of the present disclosure will be described as follows with reference to the accompanying drawings.

Items described in the singular herein may be provided in plural, as can be seen, for example, in the drawings. Thus, the description of a single item that is provided in plural should be understood to be applicable to the remaining plurality of items unless context indicates otherwise.

Spatially relative terms, such as "beneath," "below," "lower," "above," "upper," "top," "bottom," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

Ordinal numbers such as "first," "second," "third," "primary," "secondary," "tertiary," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be referenced elsewhere with a different ordinal number (e.g., "second" in the specification or another claim).

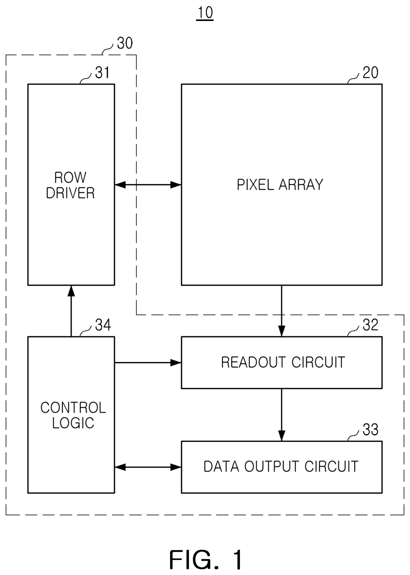

FIG. 1 is a block diagram illustrating an image sensor according to an example embodiment.

Referring to FIG. 1, an image sensor 10 may include a pixel array 20 and a peripheral circuit 30. The pixel array 20 may include a plurality of rows and a plurality of columns, and may include a plurality of pixel groups disposed in an array form. Each of the plurality of pixel groups may include a plurality of pixels and a pixel circuit. In a region of each of the plurality of pixels, a photoelectric conversion element configured to generate electric charge in response to light may be disposed. The photoelectric conversion element may be connected to a pixel circuit configured to generate and output a signal corresponding to electric charge generated by the photoelectric conversion element.

A pixel may be implemented by the photoelectric conversion element and the pixel circuit. The photoelectric conversion element may be a photodiode formed of a semiconductor material, and/or an organic photodiode formed of an organic material. In an example embodiment, sizes of the plurality of photodiodes included in one pixel group may be the same.

For example, the pixel circuit may include a plurality of transistors and capacitors. A capacitor may store electric charges generated excessively by a photodiode and may be connected to the photodiode through at least one transistor. In an example embodiment, the capacitor may be a metal-insulator-metal (MIM) capacitor.

The peripheral circuit 30 may include circuits for controlling the pixel array 20. For example, the peripheral circuit 30 may include a row driver 31, a readout circuit 32, a data output circuit 33, and a control logic 34. The row driver 31 may drive the pixel array 20 as a row ROW line unit. For example, the row driver 31 may input control signals for controlling turning on/off each transistor included in the pixel circuit to the pixel array 20 as a row line unit.

Among the pixels, pixels disposed in the same position in the row ROW direction (horizontal direction in FIG. 1) may share the same column line. Pixels disposed in the same position in the column COLUMN direction (vertical direction in FIG. 1) may be simultaneously selected by the row driver 31 and may output pixel signals through the column lines. In an example embodiment, the readout circuit 32 may simultaneously receive signals from pixels selected by the row driver 31 through the column lines. For example, the readout circuit 32 may receive a reset voltage and a signal voltage in order from each of a plurality of pixels, and the signal voltage may be obtained by reflecting electric charges generated by a photodiode of each pixel region in a reset voltage.

The readout circuit 32 may include a plurality of correlated double samplers and a plurality of counters, and the correlated double samplers may be connected to the pixels through the column lines. For example, one correlated double sampler and one counter may be connected to one column line. The correlated double samplers may read voltage signals from pixels connected to the row line selected by the row line select signal of the row driver 31 through the column lines. One input terminal of input terminals of each of the correlated double samplers may be connected to the column lines, and the other input terminal may receive a ramp voltage.

An output terminal of each of the correlated double samplers may be connected to counters, and the counters may generate a digital pixel signal by counting the time period in which an output of each of the correlated double samplers is maintained at a specific voltage. For example, the counter may convert the output of the correlated double sampler into a digital pixel signal by counting the time period in which a ramp voltage input to the correlated double sampler is greater than the voltage of the column line. The data output circuit 33 may include a memory such as a latch and a buffer circuit temporarily storing the digital pixel signal.

The control logic 34 may include a timing controller for controlling an operation timing of the row driver 31, the readout circuit 32, and the data output circuit 33. In example embodiments, the control logic 34 may determine a data format to be output by the data output circuit 33, or may perform preprocessing of the data to be output by the data output circuit 33.

In an example embodiment, the readout circuit 32 may execute a readout operation for each of a plurality of pixel groups two or more times. For example, when one of a plurality of row lines is selected, the readout circuit 32 may read a signal corresponding to electric charges generated by exposure of a pixel group arranged along the selected row line to light. In an example embodiment, the readout circuit 32 may read a signal corresponding to electric charges generated by the pixel groups during a single exposure time period multiple times.

The readout circuit 32 may obtain signals from the pixel groups under different operation conditions. For example, the readout circuit 32 may execute at least one readout operation under conditions in which a conversion gain of each of pixel groups is large and small. The conversion gain of each of the plurality of pixels may vary depending on turning on/off of the transistor connected to the floating diffusion node of each of pixels.

As described above, each of the plurality of pixel groups may include a capacitor. During the exposure time period, electric charge generated by the photodiode, in excess of the full well capacity (FWC) of the photodiode, may be transferred to the capacitor and stored, and the readout circuit 32 may execute a readout operation of obtaining a signal corresponding to electric charge stored in the capacitor. By generating an image using the signal obtained from the pixel groups under different operation conditions, the readout circuit 32 may expand intensity of light range which the image sensor 10 may represent and a dynamic range may improve.

In an example embodiment, the number of photodiodes actively electrically connected to a capacitor of each of the plurality of pixel groups may be controlled. By controlling the number of photodiodes actively electrically connected to the capacitor during the exposure time period, the amount of electric charge generated in excess of FWC of the photodiode, and moving to and stored in the capacitor may be selectively controlled. When the number of photodiodes actively electrically connected to the capacitor during the exposure time period is reduced, the amount of electric charge moving to and stored in the capacitor may be reduced. Accordingly, sensitivity of the readout operation of reading the voltage corresponding to electric charge stored in the capacitor may be improved. As used herein, items described as being "electrically connected" are configured such that an electrical signal can be passed from one item to the other. Therefore, a passive electrically conductive component (e.g., a wire, pad, internal electrical line, etc.) physically connected to a passive electrically insulative component (e.g., a prepreg layer of a printed circuit board, an electrically insulative adhesive connecting two devices, an electrically insulative underfill or mold layer, etc.) is not electrically connected to that component. Moreover, items that are "directly electrically connected," to each other are electrically connected through one or more passive elements, such as, for example, wires, pads, internal electrical lines, through vias, etc. Directly electrically connected elements may be directly physically connected and directly electrically connected. Directly electrically connected components do not include components electrically connected through active elements, such as transistors or diodes. Components described as "actively electrically connected" are connected so that a signal or voltage or charges can pass from one component to the other, based on an active component disposed therebetween that is an active state or that is subject to excess electric charge so that charges can pass through the active component even if it is not controlled to be in an active state. For example, if a transistor is between two components respectively connected to the source and drain of the transistor, the two components are actively electrically connected when the transistor is in an on state. As another example, if a photodiode connected to a source of a transistor includes sufficient excess charges so that the charges pass through the transistor to a node at the drain, the photodiode is actively electrically connected to the node.

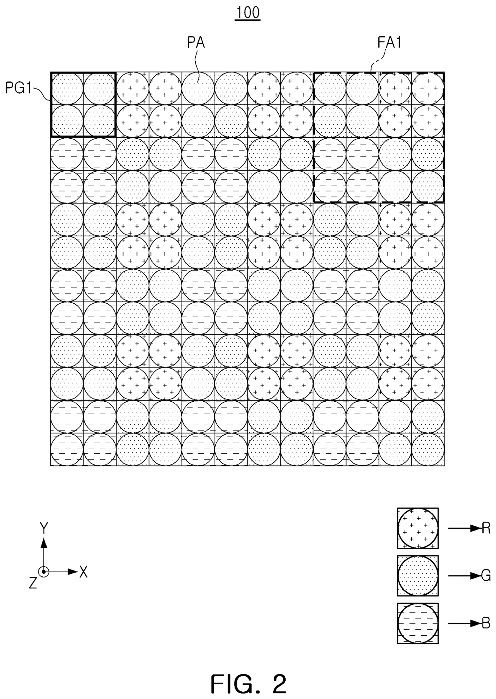

FIG. 2 is a diagram illustrating a pixel array structure of an image sensor according to an example embodiment.

Referring to FIG. 2, a pixel array 100 of an image sensor according to an example embodiment may include a plurality of pixel groups PG1 arranged in a first direction (X-axis direction) and a second direction (Y-axis direction). Each of the plurality of pixel groups PG1 may include pixel regions PA.

The pixel array 100 according to an example embodiment may include a color filter scheme having an array configured to generate an image having a tetra pattern. In an example embodiment illustrated in FIG. 2, the pixel array 100 may have a 4x4 tetra color filter array FA1 in which each of red, green, and blue are disposed in a 2x2 form. Each of the plurality of pixel groups PG1 may include 2x2 PD (photodiode) regions PA. The 2x2 PD regions PA included in the plurality of pixel groups PG1 may include color filters of the same color. However, the array of color filters may not be limited thereto. For example, each of the PD regions PA may comprise at least one photodiode.

In an example embodiment illustrated in FIG. 2, each of the plurality of pixel groups PG1 may include one capacitor and four photodiodes. According to an example embodiment, sensitivity of a readout operation of reading a voltage corresponding to electric charge stored in a capacitor may be controlled by controlling the number of photodiodes connected to the capacitor in each of the plurality of pixel groups PG1.

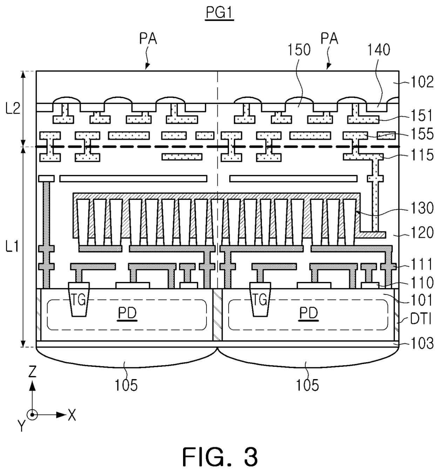

FIG. 3 is a diagram illustrating a structure of a pixel group included in an image sensor according to an example embodiment.

The pixel group PG1 illustrated in FIG. 3 is a diagram illustrating a cross-section of the pixel group PG1 of the pixel array 100 illustrated in FIG. 2, according to one example. For example, FIG. 3 is a diagram illustrating a cross-section of two PD regions PA arranged in the first direction in the pixel group PG1 in FIG. 2.

The image sensor according to an example embodiment may include a first layer L1 and a second layer L2. The first layer L1 and the second layer L2 may be stacked in the third direction (Z-axis direction). The first layer L1 may include the first substrate 101. The first substrate 101 may have a first surface and a second surface parallel to the first surface. A first interlayer insulating layer 120 may be disposed on the first surface of the first substrate 101. A color filter 103 and a microlens 105 may be disposed on the second surface of the first substrate 101. The pixel group PG1 may be defined by a device isolation film DTI. For example, the device isolation film DTI may be an insulating film for isolating the pixel groups PG1 from each other.

Referring to FIGS. 2 and 3, a plurality of photodiodes PD and a plurality of transistors 110 may be formed on or in the first substrate 101. The device isolation film DTI may be an insulating film for isolating photodiodes PD included in the pixel group PG1 from each other. The plurality of transistors 110 may be connected to each other by metal wirings 111 and may provide a pixel circuit connected to the photodiodes PD.

The photodiodes PD may be disposed in the first substrate 101 and may be defined by the device isolation film DTI. Specifically, referring to FIG. 3, the device isolation film DTI disposed between the photodiodes PD may be an insulating film for improving performance of the image sensor by controlling movement of electrons in one pixel region PA. Incident light may be incident to one surface of the first layer L1. For example, incident light may be incident in the first direction from the outside of the image sensor. One surface of the first substrate 101 may be used to dispose the plurality of transistors 110 for processing an electrical signal generated by the photodiodes PD.

The plurality of transistors 110 may include a transfer transistor. A partial region of a gate TG of the transfer transistor may overlap the photodiode PD. According to an example embodiment illustrated in FIG. 3, the gate TG of the transfer transistor may be formed as a vertical transfer gate and may be a single transfer gate.

Differently from an example embodiment illustrated in FIG. 3, the gate TG of the transfer transistor may be a planar transfer gate or may be formed in a shape in which a planar transfer gate and a vertical transfer gate are combined. Also, the gate TG of the transfer transistor may be a dual transfer gate. However, the shape of the gate TG of the transfer transistor and/or the number of the gates may not be limited thereto.

The metal wirings 111 may be disposed in a first interlayer insulating layer 120 formed on a first surface of a first substrate 101. An uppermost wiring 115 disposed on an uppermost end of the first interlayer insulating layer 120 may be connected to the uppermost end wiring 155 of the second layer L2.

In an example embodiment illustrated in FIG. 3, a capacitor 130 may be connected to the plurality of transistors 110 and included in a pixel circuit. The capacitor 130 may be disposed in the first interlayer insulating layer 120. One pixel group PG1 may include one capacitor 130. For example, the plurality of PD regions PA included in the pixel group PG1 may share one capacitor 130.

As an example, the capacitor 130 may be configured as a MIM capacitor having a multi-metal layer structure including a plurality of metal layers and a plurality of dielectric layers. In an example embodiment illustrated in FIG. 3, the plurality of metal layers and the plurality of dielectric layers may be alternately stacked in the first direction (X-axis direction). Differently from an example embodiment illustrated in FIG. 3, the plurality of metal layers and the plurality of dielectric layers may be alternately stacked in the third direction. The capacitor 130 may overlap photodiodes PD included in a pixel region group PAG in the third direction.

A portion of the metal layer of the capacitor 130 may be connected to a peripheral circuit of the second layer L2. Accordingly, a constant voltage may be applied to a portion of the metal layer. The other portion of the metal layer of the capacitor 130 may be connected to at least one of the photodiodes PD. Accordingly, electric charges generated in excess of FWC of the at least one photodiode connected to the capacitor 130 may be stored in the capacitor 130.

The second layer L2 may include a second substrate 102, and a plurality of transistors 140 may be formed on the second substrate 102. The plurality of transistors 140 may be connected to each other by metal wirings 151 disposed in the second interlayer insulating layer 150 and may provide a peripheral circuit for driving the pixel array, such as a row driver and a readout circuit. An uppermost wiring 155 disposed in an uppermost portion in the second interlayer insulating layer 150 may be connected to the uppermost end wiring 115 of the first layer L1.

In an example embodiment, a plurality of first conductive pads may be formed on one surface of the first layer L1, and a plurality of second conductive pads may be formed on one surface of the second layer L2. The first and second conductive pads may be disposed to face each other. Accordingly, the one surface of the first layer L1 and the one surface of the second layer L2 may be bonded to each other by hybrid-bonding or direct-bonding without a connecting member such as a metal bump. However, an example embodiment thereof is not limited thereto.

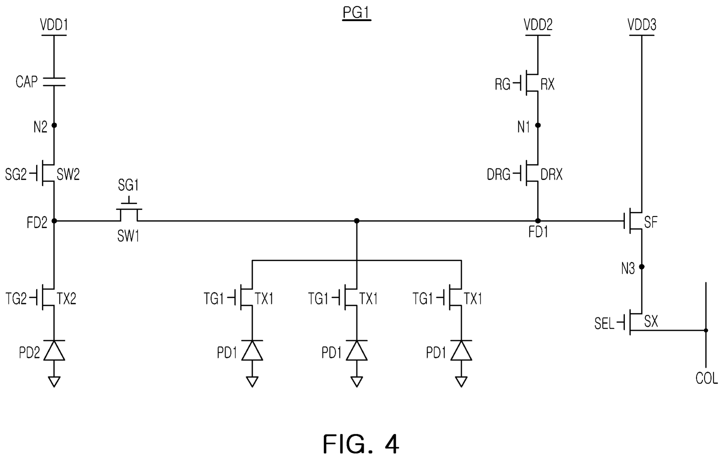

FIG. 4 is a circuit diagram illustrating a pixel group according to an example embodiment.

In an example embodiment illustrated in FIG. 4, a pixel group PG1 included in an image sensor may include a plurality of photodiodes PD1 and PD2 and a pixel circuit. The plurality of photodiodes PD1 and PD2 may include at least one first photodiode PD1 (e.g., at least one primary photodiode, which may be a first-type photodiode) and at least one second photodiode PD2 (e.g., at least one secondary photodiode, which may be a second-type photodiode). The first-type photodiode(s) may differ from the second-type photodiode(s) in one of more of their function, layout, or interconnections.

In an example embodiment illustrated in FIG. 4, a pixel group PG1 may include a total of four photodiodes. The pixel group PG1 may include three first photodiodes PD1 and one second photodiode PD2. However, the number of the first and second photodiodes may not be limited thereto. The sizes of each first photodiode PD1 and the second photodiode PD2 may be the same. Accordingly, light-receiving areas of the first photodiodes PD1 and the second photodiode PD2 may be the same.

According to an example embodiment illustrated in FIG. 4, three first photodiodes PD1 may be connected in parallel to each other between a first floating diffusion node FD1 and a reference node. In this case, the reference node may be a ground node.

The pixel circuit may include a first floating diffusion node FD1, a second floating diffusion node FD2, a first transfer transistor TX1 (e.g., a plurality of first transfer transistors TX1, also described as primary transfer transistors), a second transfer transistor TX2 (also described as a secondary transfer transistor), a gain control transistor DRX, a reset transistor RX, an amplification transistor SF, a select transistor SX, a first switch transistor SW1, and a second switch transistor SW2. Control signals TG1, TG2, DRG, RG, SEL, SG1, and SG2 for controlling a plurality of transistors included in the pixel circuit may be output by a row driver.

In the pixel circuits of the pixel group PG1 according to an example embodiment, a capacitor CAP may be included. During an exposure time period, at least one of the plurality of photodiodes PD1 and PD2 included in the pixel group PG1 may be electrically connected to the capacitor CAP.

The first floating diffusion node FD1 may be connected to the first photodiodes PD1 through the first transfer transistors TX1. When the first transfer transistors TX1 are turned on by the first transfer control signal TG1, electric charge of the first photodiodes PD1 may be stored in the first floating diffusion node FD1, which may be a floating diffusion region.

The second floating diffusion node FD2, which may also be a floating diffusion region, may be connected to the second photodiode PD2 through the second transfer transistor TX2. When the second transfer transistor TX2 is turned on by the second transfer control signal TG2, electric charge of the second photodiode PD2 may be stored in the second floating diffusion node FD2. In a situation where more than one second photodiode is included, the plurality of second photodiodes PD2 may be connected in parallel to each other between a second floating diffusion node FD2 and the reference node, and each second photodiode PD2 may be connected in series with a second transfer transistor TX2.

The first switch transistor SW1 may be connected between the first floating diffusion node FD1 and the second floating diffusion node FD2. In an operation of transferring electric charge generated by the second photodiode PD2 to the first floating diffusion node FD1, the first switch transistor SW1 may be turned on by the first switch control signal SG1.

The capacitor CAP and the second switch transistor SW2 may be connected to each other in series between the first power node and the second floating diffusion node FD2. In an example embodiment illustrated in FIG. 4, the capacitor CAP may be connected between the first power node and the second node N2, and the second switch transistor SW2 may be connected between the second node N2 and the second floating diffusion node FD2. The first power node may be a node supplying the first power voltage VDD1.

A reset transistor RX and a gain control transistor DRX may be connected to each other in series between the second power node and the first floating diffusion node FD1. In an example embodiment illustrated in FIG. 4, the reset transistor RX may be connected between the second power node and the first node N1, and the gain control transistor DRX may be connected between the first node N1 and the first floating diffusion node FD1. The second power node may be a node supplying the second power voltage VDD2. In example embodiments, the second power voltage VDD2 may be the same voltage as the first power voltage VDD1, or may be a voltage different from the first power voltage VDD1.

When the gain control transistor DRX is turned on by the gain control signal DRG, capacitance of the first floating diffusion node FD1 may increase, such that the conversion gain of the pixel group PG1 may decrease. Conversely, when the gain control transistor DRX is turned off, the conversion gain of the pixel group PG1 may increase.

The gate of the amplification transistor SF may be connected to the first floating diffusion node FD1, and the amplification transistor SF may be connected between the third power node and the select transistor SX. The third power node may be a node supplying the third power voltage VDD3. In example embodiments, the third power voltage VDD3 may be the same as at least one of the first power voltage VDD1 and the second power voltage VDD2. In an example embodiment, the third power voltage VDD3 may be equal to the second power voltage VDD2 and may be greater than the first power voltage VDD1. Also, in an example embodiment, the third power voltage VDD3 may be greater than the first power voltage VDD1 and the second power voltage VDD2.

The amplification transistor SF may operate as a source-follower amplifier and may generate a signal by amplifying the voltage of the first floating diffusion node FD1. The signal generated by the amplification transistor SF may be output to the column line COL by an operation of turning-on the select transistor SX. The column line COL may be connected to one of input terminals of the correlated double sampler, and the correlated double sampler may transfer a signal output by the column line COL and an output signal determined by the ramp voltage to the counter.

An operation of the pixel group PG1 may include a shutter operation, an exposure operation, and a readout operation. In the shutter operation, electric charges of the first and second floating diffusion nodes FD1 and FD2 and the first and second photodiodes PD1 and PD2 may be removed. In the exposure operation, the first and second photodiodes PD1 and PD2 may be exposed to light for a predetermined exposure time period and may generate electric charges.

In an example embodiment, electric charge generated in excess of the FWC of the second photodiode PD2 may be stored in the capacitor CAP, and electric charge generated in excess of the FWC of each of the first photodiodes PD1 may be released through the second power node. Accordingly, during the exposure time period, only electric charge generated in excess of the FWC of the second photodiode PD2 may be stored in the capacitor CAP.

In the readout operation, the voltage of the first floating diffusion node FD1 may be amplified and may be output to the column line COL, and for example, the reset voltage and the signal voltage may be output to the column line COL. The reset voltage may be output by the pixel circuit to the column line COL in the state in which the first floating diffusion node FD1 is reset, and the signal voltage may be output by the pixel circuit to the column line COL in the state in which at least a portion of electric charge generated by the photodiode PD is stored in the first floating diffusion node FD1.

In an example embodiment, the operation in which the pixel circuit outputs the voltage to the column line COL after one exposure time period may be executed two or more times. For example, the readout operation executed after one exposure time period may include a plurality of readout operations executed in sequence. In at least a portion of the plurality of readout operations, conversion gains of the pixel groups PG1 may be configured differently.

In an example embodiment, the readout operation may include a high conversion gain (HCG) readout operation executed under a condition in which the pixel group PG1 has a relatively large conversion gain, and a low conversion gain (LCG) readout operation executed under a condition in which the pixel group PG1 has a relatively small conversion gain. Also, the readout operation may include a lateral overflow integrated capacitor (LOFIC) readout operation of reading a voltage corresponding to electric charges generated above the FWC of the second photodiode PD2 during the exposure time period and stored in the capacitor CAP by overflow.

In an example embodiment, among the plurality of photodiodes PD1 and PD2 included in the pixel group PG1, only the second photodiode PD2 is actively electrically connected to the capacitor CAP during the exposure time period. Accordingly, the amount of electric charge stored in the capacitor CAP during the exposure time period may be reduced, thereby improving sensitivity of the LOFIC readout operation. Accordingly, a high dynamic range (HDR) may be varied, or a relative level (decibel, dB) of a signal noise ratio (SNR) may be improved.

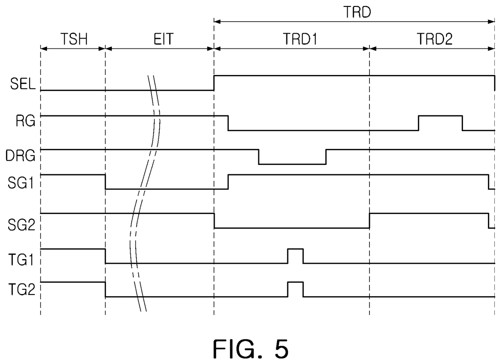

FIG. 5 is a diagram illustrating operations of a pixel group according to the example embodiment illustrated in FIG. 4.

FIG. 5 illustrates a shutter operation, exposure operation, and readout operation of one pixel group PG1. In an operation of pixel group PG1 described with reference to FIGS. 2 to 4, turning on/off of transistors SX, RX, DRX, SW1 and SW2, TX1, and TX2 included in the pixel group PG1 may be determined by control signals SEL, RG, DRG, SG1, SG2, TG1, and TG2 output by the row driver.

During the shutter operation time TSH of the pixel group PG1, the select transistor SX are turned off, and the first transfer transistor TX1, the second transfer transistor TX2, the gain control transistor DRX, the reset transistor RX, the first switch transistor SW1, and the second switch transistor SW2 is turned on. Accordingly, electric charges of the first photodiode PD1, the second photodiodes PD2, the first floating diffusion node FD1, the second floating diffusion node FD2, and the capacitor CAP may be removed by the first power voltage VDD1 and the second power voltage VDD2.

During the exposure time period EIT, the reset transistor RX, the gain control transistor DRX, and the second switch transistor SW2 may be turned on, and the other transistors SX, SW1, TX1, and TX2 may be turned off. The first photodiodes PD1 and the second photodiode PD2 may generate electric charges in response to light, and the generated electric charges may remain in the first photodiodes PD1 and the second photodiode PD2. However, in a circumstance in which relatively strong light is input, electric charges may be generated above the FWC of the first photodiodes PD1 and the second photodiode PD2. Hereinafter, for ease of description, electric charges generated above the FWC in each of the first photodiode PD1 and the second photodiode PD2 may be defined as excess electric charges.

When excess electric charge is generated by the first photodiode PD1, the voltage of the node at which the first transfer transistor TX1 and the first photodiode PD1 are connected to each other, for example, the source of the first transfer transistor TX1, may decrease due to the excess electric charge. Accordingly, even though the first transfer control signal TG1 input to the gate of the first transfer transistor TX1 is maintained at a voltage corresponding to a logic low, a path for moving electric charge may be formed through a channel of the first transfer transistor TX1. The excess electric charge of the first photodiode PD1 may move to the first floating diffusion node FD1.

In this case, since the gain control signal DRG input to the gate of the gain control transistor DRX and the reset control signal RG input to the gate of the reset transistor RX are maintained at a voltage corresponding to a logic high, the excess electric charge of the first photodiode PD1 may be released to the second power node.

Also, in an example embodiment, when excess electric charge is generated by the second photodiode PD2, the voltage of the node at which the second transfer transistor TX2 and the second photodiode PD2 are connected, for example, the voltage of the source of the second transfer transistor TX2, may decrease due to the excess electric charge. Accordingly, even though the second transfer control signal TG2 input to the gate of the second transfer transistor TX2 is maintained at a voltage corresponding to a logic low, a path for moving electric charge may be formed through the channel of the second transfer transistor TX2. The excess electric charge of the second photodiode PD2 may move to the second floating diffusion node FD2.

In an example embodiment, the voltage of the source of the second switch transistor SW2 may decrease due to electric charge of the second floating diffusion node FD2. In addition, the second switch control signal SG2 input to the gate of the second switch transistor SW2 is maintained at a voltage corresponding to a logic high, so a path for moving electric charge may be formed through a channel of the second switch transistor SW2, and the excess electric charge moving to the second floating diffusion node FD2 may move to the capacitor CAP and may be stored therein. Accordingly, only the excess electric charge of the second photodiode PD2 may be stored in the capacitor CAP during the exposure time period EIT. The first switch transistor SW1 may be turned off such that the excess electric charge may not move to the first floating diffusion node FD1.

The pixel group PG1 may execute a readout operation after the exposure time period EIT has elapsed. The readout operation may include the first and second readout operations. In the first readout operation, the pixel group PG1 may output a voltage corresponding to electric charge generated by the first and second photodiodes PD1 and PD2 under a high conversion gain condition and a low conversion gain condition, respectively. In the second readout operation, the pixel group PG1 may output a voltage corresponding to the excess electric charge generated by the second photodiode PD2 and stored in the capacitor CAP.

Referring to FIG. 5, the reset voltage may be output twice. The first reset voltage may be output in a state in which the gain control transistor DRX is turned on, and the second reset voltage may be output in a state in which the gain control transistor DRX is turned off. The first reset voltage may be a reset voltage output under a condition in which the pixel group PG1 has a low conversion gain, and the second reset voltage may be a reset voltage output under a condition in which the pixel group PG1 has a high conversion gain.

Referring to FIG. 5, in the first readout time period TRD1, the select transistor SX may be turned on first by the select control signal SEL, and the second switch transistor SW2 may be turned off by the second switch control signal SG2. Thereafter, the reset transistor RX may be turned off by the reset control signal RG, the first switch transistor SW1 may be turned on by the first switch control signal SG1, and the amplification transistor SF may amplify the voltage of the first floating diffusion node FD1 and may output the first reset voltage.

When the first reset voltage is output (e.g., after the first reset voltage has been output), the gain control transistor DRX may be turned off by the gain control signal DRG, such that the first node N1 and the first floating diffusion node FD1 may be isolated from each other. Capacitance of the first floating diffusion node FD1 may be maintained relatively small, and the second reset voltage may be output under the condition in which the pixel group PG1 has a high conversion gain.

Thereafter, the first transfer transistors TX1 and the second transfer transistor TX2 may be turned on, and electric charge of the first photodiodes PD1 and the second photodiode PD2 may be transferred to the first floating diffusion node FD1. The amplification transistor SF may output the first signal voltage, which is the voltage of the first floating diffusion node FD1, to the column line COL. Since the gain control transistor DRX maintains the turned-off state, the first signal voltage may be output under the condition in which the pixel group PG1 has a high conversion gain.

The readout circuit connected to the column line COL may generate the first pixel signal from a difference between the second reset voltage and the first signal voltage. The first pixel signal may be a signal for covering the relatively low illuminance of the first range.

Referring to FIG. 5, while the pixel group PG1 outputs the first signal voltage to the column line COL, the gain control transistor DRX may be turned on by the gain control signal DRG. Accordingly, capacitance of the first floating diffusion node FD1 may be maintained high, and the second signal voltage may be output under the condition in which the pixel group PG1 has a low conversion gain.

The readout circuit connected to the column line COL may generate the second pixel signal from the difference between the first reset voltage and the second signal voltage. The second pixel signal may be a signal for covering illuminance of the second range higher than the first range.

Thereafter, during the second readout time period TRD2 of the pixel group PG1, the second switch transistor SW2 may be turned on, such that electric charge stored in the capacitor CAP may move to the first floating diffusion node FD1. Through the column line COL, a signal voltage corresponding to electric charge stored in the capacitor CAP may be output.

After the signal voltage is output, the row driver may turn on the reset transistor RX. Accordingly, a reset operation in which electric charges of the first floating diffusion node FD1, the second floating diffusion node FD2, and the capacitor CAP are removed may be executed, and the reset voltage may be output through the column line COL. The readout circuit may generate a third pixel signal using a difference between the reset voltage output by pixel group PG1 and the signal voltage. The third pixel signal may be a signal for covering illuminance of the third range higher than the second range.

As described above, only the excess electric charge generated in excess of the FWC of the second photodiode PD2 during the exposure time period EIT may be stored in the capacitor CAP. Electric charge may be stored in the capacitor CAP under the condition in which strong light generating electric charge in excess of the FWC of the second photodiode PD2 enters the pixel group PG1. Accordingly, relatively high illuminance may be covered using the third pixel signal generated by electric charge stored in the capacitor CAP.

The first and second pixel signals may be generated by electric charge stored in the four photodiodes PD1 and PD2. Alternatively, the third pixel signal may be generated by the excess electric charge generated in excess of the FWC of one second photodiode PD2. As compared with a general third pixel signal generated by the excess electric charge of four photodiodes PD1 and PD2, sensitivity of the third pixel signal generated by the excess electric charge of one second photodiode PD2 in an example embodiment may provide about four times improved sensitivity.

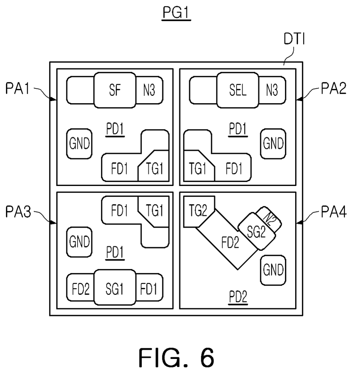

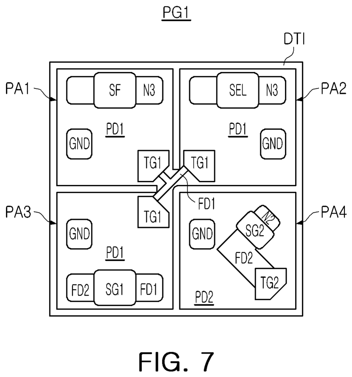

FIG. 6 is a diagram illustrating a layout of a pixel group according to the example embodiment illustrated in FIG. 4. FIG. 7 is a diagram illustrating a layout of a pixel group according to the example embodiment illustrated in FIG. 4.

FIGS. 6 and 7 may be diagrams illustrating a layout of the pixel group PG1 described with reference to FIGS. 2 to 4. First, referring to FIGS. 6 and 7, the device isolation film DTI may be an insulating film for isolating the pixel groups PG1 from each other and isolating a plurality of photodiodes PD included in the pixel group PG1 from each other. The pixel group PG1 may include a plurality of pixel regions PA1-PA4.

In an example embodiment illustrated in FIGS. 6 and 7, the pixel group PG1 may include four pixel regions PA1-PA4 disposed in a 2x2 structure, and each of the four pixel regions PA1-PA4 may include a photodiode. Referring to FIGS. 2 to 4 together, the first photodiode PD1 (e.g., primary photodiode) may be disposed in each of the first to third pixel regions PA1-PA3, and the second photodiode PD2 (e.g., secondary photodiode) may be disposed in the fourth pixel region PA4. The ground region GND to which a ground voltage is applied may be disposed in each of the first to fourth pixel regions PA1-PA4.

Referring first to FIG. 6, a gate TG1 of the first transfer transistor and a gate SF of the amplification transistor may be disposed in the first pixel region PA1. A high-concentration doping region of the gate TG1 around the first transfer transistor may be included in the first floating diffusion region FD1. The high-concentration doping regions disposed on both sides of the gate SF of the amplification transistor may be included in the amplification transistor. The region disposed on one side of the gate SF of the amplification transistor may be included in the third node region N3, and the third power voltage may be applied to the region disposed on the other side.

In the second pixel region PA2, the gate TG1 of the first transfer transistor and the gate SEL of the select transistor may be disposed. The high-concentration doping region of the gate TG1 around the first transfer transistor may be included in the first floating diffusion region FD1. The gate SEL of the select transistor and the high-concentration doping regions disposed on both sides may be included in the select transistor. The region disposed on one side of the gate SEL of the select transistor may be included in the third node region N3, and the region disposed on the other side may be connected to the column line.

In the third pixel region PA3, the gate TG1 of the first transfer transistor and the gate SG1 of the first switch transistor may be disposed. A high-concentration doping region of the gate TG1 around the first transfer transistor may be included in the first floating diffusion region FD1. The high-concentration doping regions disposed on both sides of the gate SG1 of the first switch transistor may be included in the first switch transistor. The region disposed on one side of the gate SG1 of the first switch transistor may be included in the first floating diffusion region FD1, and the region disposed on the other side may be included in the second floating diffusion region FD2.

In the fourth pixel region PA4, the gate TG2 of the second transfer transistor and the gate SG2 of the second switch transistor may be disposed. A high-concentration doping region between the gate TG2 of the second transfer transistor and the gate SG2 of the second switch transistor may be included in the second floating diffusion region FD2. The high-concentration doping region disposed on one side of the gate SG2 of the second switch transistor may be included in the second node region N2.

Comparing FIGS. 6 and 7, layouts of the pixel group PG1 may be similar other than the difference in the formation of the first floating diffusion region FD1. Referring to FIG. 7, the first floating diffusion region FD1 may be shared in the first to third pixel regions PA1-PA3. For example, the first floating diffusion region FD1 may be disposed in the region from which the partial region of the device isolation film between the first to third pixel regions PA1-PA3 may be removed.

In an example embodiment different from the example illustrated in FIG. 7, the first floating diffusion region FD1 may be disposed in the region from which the partial region of the device isolation film between the first to fourth pixel regions PA1-PA4 is removed, such that the first floating diffusion region FD1 may be shared in the first to fourth pixel regions PA1-PA4.

Also, in an example embodiment different from the example illustrated in FIG. 7, a partial region of the device isolation film between the first and second pixel regions PA1 and PA2 may be removed, and a partial region of the device isolation film between the third and fourth pixel regions PA3 and PA4 may be removed. A first floating diffusion region FD1 may be disposed in each of the partial regions. The first and second pixel regions PA1 and PA2 and the third and fourth pixel regions PA3 and PA4 may share the first floating diffusion region FD1. However, the formation position of the first floating diffusion region FD1 and/or the relationship of the shared pixel region may not be limited thereto.

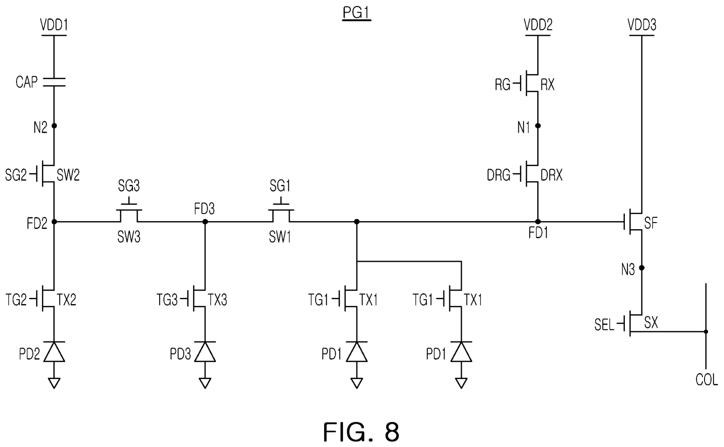

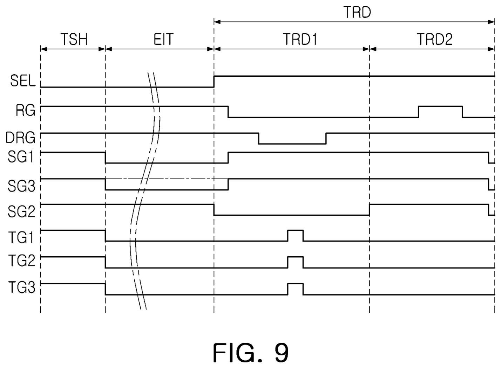

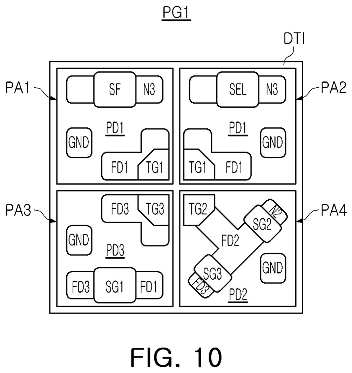

FIG. 8 is a circuit diagram illustrating a pixel group according to an example embodiment. FIG. 9 is a diagram illustrating operations of a pixel group according to the example embodiment illustrated in FIG. 8. FIG. 10 is a diagram illustrating a layout of a pixel group according to the example embodiment illustrated in FIG. 8.

FIG. 8 is a circuit diagram illustrating an example embodiment of the pixel group PG1 in FIGS. 2 and 3. In an example embodiment illustrated in FIG. 8, the pixel group PG1 included in the image sensor may include a plurality of photodiodes PD1, PD2, and PD3 and a pixel circuit. The plurality of photodiodes PD1, PD2, and PD3 may include at least one first photodiode PD1 (e.g., at least one primary photodiode), at least one second photodiode PD2 (e.g., at least one secondary photodiode), and at least one third photodiode PD3 (e.g., at least one tertiary photodiode).

According to an example embodiment illustrated in FIG. 8, two first photodiodes PD1 may be connected in parallel between a first floating diffusion node FD1 and a reference node. In this case, the reference node may be a ground node.

Comparing the pixel group PG1 in FIG. 4 with the pixel group PG1 in FIG. 8, the pixel group PG1 in FIG. 8 may further include a third photodiode PD3. In the description below, the difference will be mainly described.

First, referring to FIG. 8, the pixel group PG1 may further include a third photodiode PD3. In an example embodiment illustrated in FIG. 8, the pixel group PG1 may include a total of four photodiodes. The pixel group PG1 may include two first photodiodes PD1, one second photodiode PD2, and one third photodiode PD3. However, the number of first to third photodiodes is not limited thereto. The sizes of the first to third photodiodes PD1-PD3 may be the same. Accordingly, light-receiving areas of the first to third photodiodes PD1-PD3 may be the same.

The pixel circuit may further include a third floating diffusion node FD3 connected to the third photodiode PD3 through a third transfer transistor TX3 (e.g., a tertiary transfer transistor TX3), and a third switch transistor SW3 connected between the second floating diffusion node FD2 and the third floating diffusion node FD3. In an example embodiment, the first switch transistor SW1 may be connected between the first floating diffusion node FD1 and the third floating diffusion node FD3. Control signals TG3 and SG3 controlling the third transfer transistor TX3 and the third switch transistor SW3 may be output by a row driver.

Differently from an example embodiment illustrated in FIG. 8, when a plurality of the third photodiodes PD3 are provided, the third photodiodes PD3 may be connected in parallel between the third floating diffusion node FD3 and a reference node. In this case, the reference node may be a ground node.

At least one of the plurality of photodiodes PD1 and PD2 included in the pixel group PG1 may be electrically connected to the capacitor CAP. According to an example embodiment illustrated in FIG. 8, at least one of the first photodiode PD1 and the third photodiode PD3 may be actively electrically connected to the capacitor CAP during the exposure time period.

Referring to FIGS. 8 and 9 together, the number of photodiodes PD actively electrically connected to the capacitor CAP during the exposure time period EIT may be controlled by controlling turning on/off of the third switch transistor SW3.

In an example embodiment, when the third switch control signal SG3 is maintained at a voltage corresponding to a logic row during the exposure time period EIT, the third photodiode PD3 may not be actively electrically connected to the capacitor CAP. During the exposure time period EIT, because the third switch transistor SW3 remains off, only the excess electric charge of the second photodiode PD2 may be transferred to the second floating diffusion node FD2 and the capacitor CAP and may be stored therein. Accordingly, the pixel group PG1 in FIGS. 8 and 9 may operate in the same manner as the example embodiment described with reference to FIGS. 4 to 7.

In another example embodiment, when the third switch control signal SG3 is maintained at a voltage corresponding to a logic high during the exposure time period EIT, the third photodiode PD3 may be electrically connected to the capacitor CAP. During the exposure time period EIT, when excess electric charge is generated by the second and third photodiodes PD2 and PD3, the voltage of the source of the second and third transfer transistors TX2 and TX3 may be reduced due to the excess electric charge. A path for moving electric charge may be formed through a channel of the second and third transfer transistors TX2 and TX3, such that the excess electric charge of the second and third photodiodes PD2 and PD3 may move to the second floating diffusion node FD2.

The voltage of a source of the second switch transistor SW2 may be reduced due to electric charge of the second floating diffusion node FD2. A path for moving electric charge may be formed through a channel of the second switch transistor SW2, and the excess electric charge moving to the second floating diffusion node FD2 may move to the capacitor CAP and may be stored therein. Accordingly, only the excess electric charge of the second and third photodiodes PD2 and PD3 is stored in the capacitor CAP during the exposure time period EIT. The first switch transistor SW1 may be turned off such that the excess electric charge may not move to the first floating diffusion node FD1. Therefore, according to the embodiment of FIGS. 8 and 9, the number of photodiodes actively electrically connected to the capacitor CAP during the exposure time period EIT can be controlled and adjusted.

The pixel group PG1 may execute a readout operation after the exposure time period EIT has elapsed. The readout operation may include first and second readout operations. In the first readout operation, the pixel group PG1 may output a voltage corresponding to electric charge generated by the first to third photodiodes PD1-PD3 under a high conversion gain condition and a low conversion gain condition, respectively. In the second readout operation, the pixel group PG1 may output a voltage corresponding to the excess electric charge generated by the second and/or third photodiodes PD2 and PD3 and stored in the capacitor CAP.

The pixel group PG1 in an example embodiment illustrated in FIGS. 8 and 9 may control the amount of the excess electric charge stored in the capacitor CAP using turning on/off control of the third switch transistor SW3. Therefore, the third pixel signal may be generated by the excess electric charge of one second photodiode PD2 and/or one third photodiode PD3.

As compared to the general third pixel signal generated by the excess electric charge of four photodiodes PD1-PD3, sensitivity of the third pixel signal generated by the excess electric charge of one second photodiode PD2 in an example embodiment may provide about four times improved sensitivity, and sensitivity of the third pixel signal generated by the excess electric charge of two second and third photodiodes PD2 and PD3 in an example embodiment may provide about two times improved sensitivity.

As comparing a layout of the pixel group PG1 in FIG. 10 with the pixel group PG1 in FIG. 6, the layouts of the third and fourth pixel regions PA3 and PA4 may be different. Hereinafter, the differences of the third and fourth pixel regions PA3 and PA4 will be described.

The third photodiode PD3 may be disposed in the third pixel region PA3. The gate TG3 of the third transfer transistor and the gate SG1 of the first switch transistor may be disposed in the third pixel region PA3. The high-concentration doping region of the gate TG3 around the third transfer transistor may be included in the third floating diffusion region FD3. The high-concentration doping regions disposed on both sides of the gate SG1 of the first switch transistor may be included in the first switch transistor. The region disposed on one side of the gate SG1 of the first switch transistor may be included in the first floating diffusion region FD1, and the region disposed on the other side may be included in the third floating diffusion region FD3.

In the fourth pixel region PA4, the gate TG2 of the second transfer transistor, the gate SG2 of the second switch transistor, and the gate SG3 of the third switch transistor may be disposed. A high-concentration doping region between the gate TG2 of the second transfer transistor, the gate SG2 of the second switch transistor, and the gate SG3 of the third switch transistor may be included in the second floating diffusion region FD2. The high-concentration doping region disposed on one side of the gate SG2 of the second switch transistor may be included in the second node region N2. The high-concentration doping region disposed on one side of the gate SG3 of the third switch transistor may be included in the third floating diffusion region FD3.

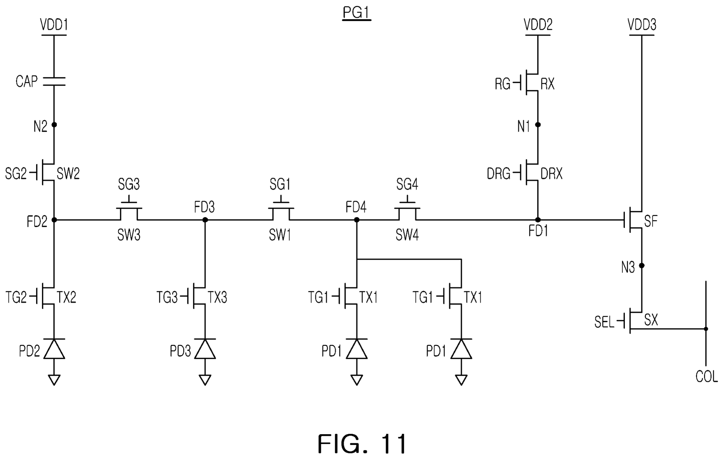

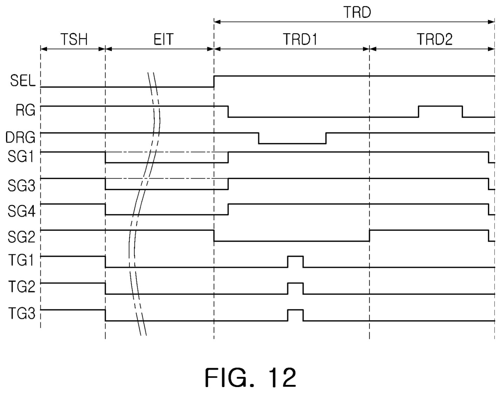

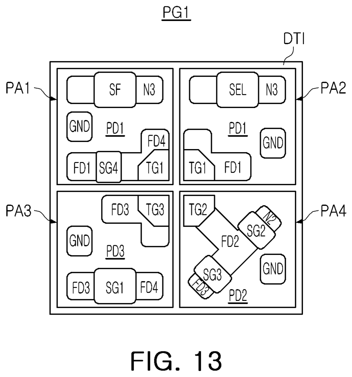

FIG. 11 is a circuit diagram illustrating a pixel group according to an example embodiment. FIG. 12 is a diagram illustrating operations of a pixel group according to the example embodiment illustrated in FIG. 11. FIG. 13 is a diagram illustrating a layout of a pixel group according to the example embodiment illustrated in FIG. 11.

FIG. 11 may be a circuit diagram illustrating an example embodiment of the pixel group PG1 in FIGS. 2 and 3. In an example embodiment illustrated in FIG. 11, the pixel group PG1 included in an image sensor may include a plurality of photodiodes PD1, PD2, and PD3 and a pixel circuit. The plurality of photodiodes PD1, PD2, and PD3 may include at least one first photodiode PD1, at least one second photodiode PD2, and at least one third photodiode PD3. Comparing the pixel group PG1 in FIG. 8 with the pixel group PG1 in FIG. 11, the pixel group PG1 in FIG. 11 may further include a fourth switch transistor SW4. The differences will be mainly described below.

Referring first to FIG. 11, the pixel group PG1 may further include a fourth switch transistor SW4 connected between the first switch transistor SW1 and the first floating diffusion node FD1. A fourth switch control signal SG4 controlling the fourth switch transistor SW4 may be output by a row driver.

Referring together to FIG. 11 and FIG. 12, the number of photodiodes PD electrically connected to the capacitor CAP during the exposure time period EIT may be controlled by controlling turning on/off of the first and third switch transistors TX1 and TX3.

In an example embodiment, when the first and third switch control signals SG1 and SG3 are maintained at a voltage corresponding to a logic low during the exposure time period EIT, the first and third photodiodes PD1 and PD3 may not be electrically connected to the capacitor CAP. During the exposure time period EIT, only the excess electric charge of the second photodiode PD2 may be transferred to the second floating diffusion node FD2 and the capacitor CAP and may be stored therein. Accordingly, the pixel group PG1 in FIGS. 8 and 9 may operate in the same manner as in the example embodiment described with reference to FIGS. 4 to 7 above.

In another example embodiment, when the third switch control signal SG3 is maintained at a voltage corresponding to a logic high and the first switch control signal SG1 is maintained at a voltage corresponding to a logic low during the exposure time period EIT, the third photodiode PD3 may be electrically connected to the capacitor CAP. The excess electric charge generated by the second and third photodiodes PD2 and PD3 during the exposure time period EIT may be transferred to the second floating diffusion node FD2 and the capacitor CAP and may be stored in the capacitor CAP. Accordingly, only the excess electric charge of the second and third photodiodes PD2 and PD3 may be stored in the capacitor CAP during the exposure time period EIT.

In another example embodiment, when the first and third switch control signals SG1 and SG3 are maintained at a voltage corresponding to a logic high during the exposure time period EIT, the first photodiodes PD1 and the third photodiode PD3 may be electrically connected to the capacitor CAP. The excess electric charge of the first to third photodiodes PD1-PD3 generated during the exposure time period EIT may move to the second floating diffusion node FD2 and the capacitor CAP and may be stored in the capacitor CAP. Accordingly, the excess electric charge of the first to third photodiodes PD1-PD3 may be stored in the capacitor CAP during the exposure time period EIT.

The pixel group PG1 may execute a readout operation after the exposure time period EIT has elapsed. The readout operation may include the first and second readout operations. In the first readout operation, the pixel group PG1 may output a voltage corresponding to electric charge generated by the first to third photodiodes PD1-PD3 under a high conversion gain condition and a low conversion gain condition, respectively. In the second readout operation, the pixel group PG1 may output a voltage corresponding to the excess electric charge generated by at least one of the first to third photodiodes PD1-PD3 and stored in the capacitor CAP.

The pixel group PG1 in an example embodiment illustrated in FIGS. 11 and 12 may control the amount of excess electric charge stored in the capacitor CAP by controlling turning on/off of the first and third switch transistors SW1 and SW3. Therefore, the third pixel signal may be generated by the excess electric charge of one second photodiode PD2 and/or one third photodiode PD3 and/or two first photodiodes PD1.

Compared to the general third pixel signal generated by the excess electric charge of four photodiodes PD1-PD3, sensitivity of the third pixel signal generated by the excess electric charge of one second photodiode PD2 in an example embodiment may provide about four times improved sensitivity, and sensitivity of the third pixel signal generated by the excess electric charge of two second and third photodiodes PD2 and PD3 in an example embodiment may provide about two times improved sensitivity. Also, sensitivity of the third pixel signal generated by the excess electric charge of four first to third photodiodes PD1-PD3 in an example embodiment may provide the same sensitivity.

Comparing the layout of the pixel group PG1 in FIG. 13 with the layout of the pixel group PG1 in FIG. 10, layouts of the first and second pixel regions PA1 and PA2 may be different. Hereinafter, the differences of the first and second pixel regions PA1 and PA2 will be discussed.

In the first pixel region PA1, the gate TG1 of the first transfer transistor, the gate SF of the amplification transistor, and the gate SG4 of the fourth switch transistor may be disposed. The high-concentration doping region between the gate TG1 of the first transfer transistor and the gate SG4 of the fourth switch transistor may be included in the fourth floating diffusion region FD4. The high-concentration doping region disposed on the other side of the gate SG4 of the fourth switch transistor may be included in the first floating diffusion region FD1.

The high-concentration doping regions disposed on both sides of the gate SF of the amplification transistor may be included in the amplification transistor. The region disposed on one side of the gate SF of the amplification transistor may be included in the third node region N3, and a third power voltage may be applied to the region disposed on the other side.

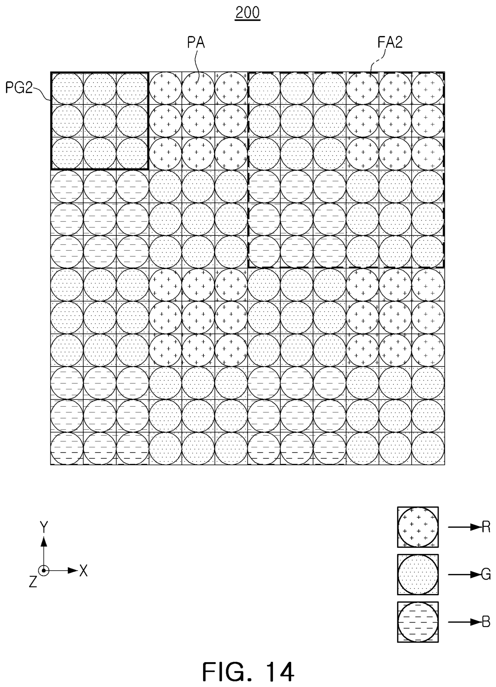

FIG. 14 is a diagram illustrating a pixel array structure of an image sensor according to an example embodiment.

Referring to FIG. 14, a pixel array 200 of an image sensor according to an example embodiment may include a plurality of pixel groups PG2 arranged in a first direction (X-axis direction) and a second direction (Y-axis direction). Each of the plurality of pixel groups PG2 may include pixel regions PA.

A pixel array 200 according to an example embodiment may include a color filter having an array configured to generate an image having a nona pattern. In an example embodiment illustrated in FIG. 14, the pixel array 200 may have a 6x6 nona color filter array FA2 in which each of red, green, and blue are disposed in a 3x3 form. Each of the plurality of pixel groups PG2 may include 3x3 pixel regions PA. The 3x3 PD regions PA included in the plurality of pixel groups PG2 may include a color filter of the same color. However, the array of color filters may not be limited thereto.

In an example embodiment illustrated in FIG. 14, each of the plurality of pixel groups PG2 may include one capacitor and nine photodiodes. According to an example embodiment, sensitivity of a readout operation of reading a voltage corresponding to electric charge stored in a capacitor may be controlled by controlling the number of photodiodes actively electrically connected to the capacitor in each of the plurality of pixel groups PG2.

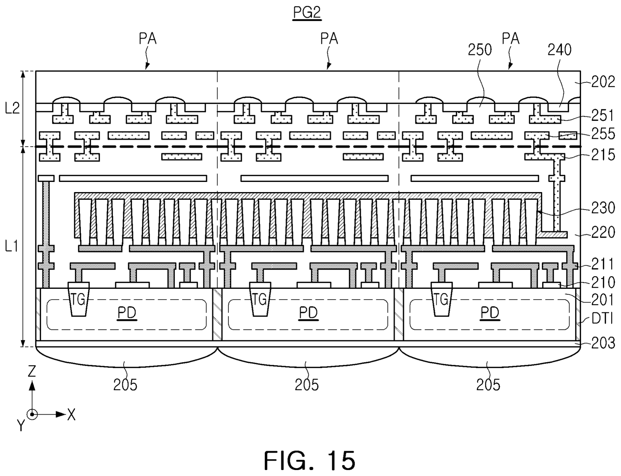

FIG. 15 is a diagram illustrating the structure of a pixel group included in an image sensor according to an example embodiment.

The pixel group PG2 illustrated in FIG. 15 may be a diagram illustrating a cross-section of the pixel group PG2 of the pixel array 200 illustrated in FIG. 14. For example, FIG. 15 illustrates a cross-section of three PD regions PA arranged in the first direction, for example in the pixel group PG2 in FIG. 14.

An image sensor according to an example embodiment may include a first layer L1 and a second layer L2. The first layer L1 and the second layer L2 may be stacked in a third direction (Z-axis direction). The first layer L1 may include a first substrate 201. The first substrate 201 may have a first surface, and a second surface parallel to the first surface. A first interlayer insulating layer 220 may be disposed on the first surface of the first substrate 201. A color filter 203 and a microlens 205 may be disposed on the second surface of the first substrate 201. A pixel group PG2 may be defined by a device isolation film DTI. For example, the device isolation film DTI may be an insulating film for isolating the pixel groups PG2 from each other.

Referring to FIGS. 14 and 15 together, a plurality of photodiodes PD and a plurality of transistors 210 may be formed on the first substrate 201. The device isolation film DTI may be an insulating film for isolating the photodiodes PD included in the pixel group PG2 from each other. The plurality of transistors 210 may be connected to each other by metal wirings 211 and may provide a pixel circuit connected to the photodiodes PD.

The photodiodes PD may be disposed in the first substrate 201 and may be defined by the device isolation film DTI. Specifically, referring to FIG. 15, the device isolation film DTI disposed between the photodiodes PD may be an insulating film for improving performance of the image sensor by controlling movement of electrons in one pixel region PA. Incident light may be incident to one surface of the first layer L1. For example, incident light may be incident in the first direction from the outside of the image sensor. One surface of the first substrate 201 may be used to dispose a plurality of transistors 210 for processing electrical signals generated by the photodiodes PD.

The plurality of transistors 210 may include a transfer transistor. A partial region of the gate TG of the transfer transistor may overlap the photodiode PD. According to an example embodiment illustrated in FIG. 15, the gate TG of the transfer transistor may be formed as a vertical transfer gate and may be a single transfer gate.

Differently from the example embodiment illustrated in FIG. 15, the gate TG of the transfer transistor may be a planar transfer gate or may be formed in a shape in which a planar transfer gate and a vertical transfer gate are combined. Also, the gate TG of the transfer transistor may be a dual transfer gate. However, the shape of the gate TG of the transfer transistor and/or the number of the gates is not limited thereto.

Metal wirings 211 may be disposed in a first interlayer insulating layer 220 formed on the first surface of a first substrate 201. Uppermost wiring 215 disposed on an uppermost end of the first interlayer insulating layer 220 may be connected to an uppermost end wiring 255 of the second layer L2.

In an example embodiment illustrated in FIG. 15, a capacitor 230 may be connected to a plurality of transistors 210 and included in a pixel circuit. The capacitor 230 may be disposed in the first interlayer insulating layer 220. One pixel group PG2 may include one capacitor 230. The plurality of PD regions PA included in the pixel group PG2 may share one capacitor 230.

As an example, the capacitor 230 may be a MIM capacitor having a multi-metal layer structure including a plurality of metal layers and a plurality of dielectric layers. In an example embodiment illustrated in FIG. 15, the plurality of metal layers and the plurality of dielectric layers may be alternately stacked in the first direction (X-axis direction). Differently from an example embodiment illustrated in FIG. 15, the plurality of metal layers and the plurality of dielectric layers may be alternately stacked in the third direction. The capacitor 230 may overlap the photodiodes PD included in the pixel region group PAG in the third direction.

A portion of the metal layer of the capacitor 230 may be connected to a peripheral circuit of the second layer L2. Accordingly, a constant voltage may be applied to a portion of the metal layer. The other portion of the metal layer of the capacitor 230 may be connected to at least one of the photodiodes PD. Accordingly, electric charges generated in excess of the FWC of the at least one photodiode connected to the capacitor 230 may be stored in the capacitor 230.

The second layer L2 may include a second substrate 202, and a plurality of transistors 240 may be formed on the second substrate 202. The plurality of transistors 240 may be connected to each other by metal wirings 251 disposed in the second interlayer insulating layer 250 and may provide a peripheral circuit for driving the pixel array, such as a row driver and a readout circuit. The uppermost wiring 255 disposed in an uppermost portion in the second interlayer insulating layer 250 may be connected to an uppermost end wiring 215 of the first layer L1.

In an example embodiment, a plurality of first conductive pads may be formed on one surface of the first layer L1, and a plurality of second conductive pads may be formed on one surface of the second layer L2. The first and second conductive pads may be disposed to face each other. Accordingly, the one surface of the first layer L1 and the one surface of the second layer L2 may be bonded to each other by hybrid-bonding or direct-bonding without a connection member such as a metal bump. However, an example embodiment thereof is not limited thereto.

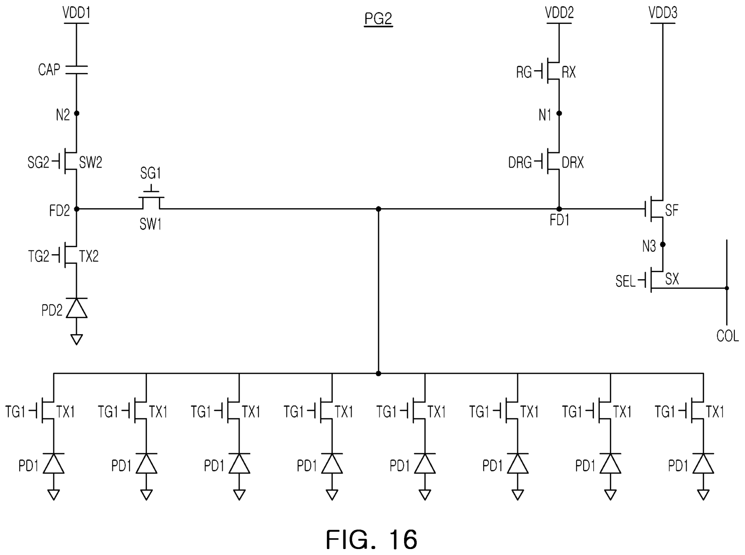

FIG. 16 is a circuit diagram illustrating a pixel group according to an example embodiment.

In an example embodiment illustrated in FIG. 16, a pixel group PG2 included in an image sensor may include a plurality of photodiodes PD1 and PD2 and a pixel circuit. The plurality of photodiodes PD1 and PD2 may include at least one first photodiode PD1 and at least one second photodiode PD2.

In an example embodiment illustrated in FIG. 16, the pixel group PG2 may include nine photodiodes. The pixel group PG2 may include eight first photodiodes PD1 and one second photodiode PD2. However, the number of the first and second photodiodes is not limited thereto. The sizes of the first photodiode PD1 and the second photodiode PD2 may be the same. Accordingly, light-receiving areas of the first photodiode PD1 and the second photodiode PD2 may be the same.

According to an example embodiment illustrated in FIG. 16, eight first photodiodes PD1 may be connected in parallel between the first floating diffusion node FD1 and the reference node. In this case, a reference node may be a ground node. Also, comparing the pixel group PG1 in FIG. 4 with the pixel group PG2 in FIG. 16, the number of the second photodiodes PD2 and the second transfer transistors TX2 may be different (e.g., a plurality of series-connected second photodiodes PD2 and second transfer transistors TX2 may be connected in parallel between the ground node and a second floating diffusion node FD2).

The pixel circuit may include a first floating diffusion node FD1, a second floating diffusion node FD2, one or more first transfer transistors TX1, one or more second transfer transistors TX2, a gain control transistor DRX, a reset transistor RX, an amplification transistor SF, a select transistor SX, a first switch transistor SW1, and a second switch transistor SW2. Control signals TG1, TG2, DRG, RG, SEL, SG1, and SG2 for controlling a plurality of transistors included in the pixel circuit may be output by a row driver.

In pixel circuits of the pixel group PG2 according to an example embodiment, one more capacitor CAP may be included. During the exposure time period, at least one of the plurality of photodiodes PD1 and PD2 included in the pixel group PG2 may be actively electrically connected to the capacitor CAP.

The first floating diffusion node FD1 may be connected to the first photodiodes PD1 through the first transfer transistors TX1. When the first transfer transistors TX1 are turned on by the first transfer control signal TG1, electric charge of the first photodiodes PD1 may be stored in the first floating diffusion node FD1.

The second floating diffusion node FD2 may be connected to the second photodiode PD2 through the second transfer transistor TX2. When the second transfer transistor TX2 is turned on by the second transfer control signal TG2, electric charge of the second photodiode PD2 may be stored in the second floating diffusion node FD2.

The first switch transistor SW1 may be connected between the first floating diffusion node FD1 and the second floating diffusion node FD2. In an operation of transferring electric charge generated by the second photodiode PD2 to the first floating diffusion node FD1, the first switch transistor SW1 may be turned on by the first switch control signal SG1.

The capacitor CAP and the second switch transistor SW2 may be connected to each other in series between the first power node and the second floating diffusion node FD2. In an example embodiment illustrated in FIG. 16, the capacitor CAP may be connected between the first power node and the second node N2, and the second switch transistor SW2 may be connected between the second node N2 and the second floating diffusion node FD2. The first power node may be a node supplying the first power voltage VDD1.

A reset transistor RX and a gain control transistor DRX may be connected to each other in series between the second power node and the first floating diffusion node FD1. In an example embodiment illustrated in FIG. 16, the reset transistor RX may be connected between the second power node and the first node N1, and the gain control transistor DRX may be connected between the first node N1 and the first floating diffusion node FD1. The second power node may be a node supplying the second power voltage VDD2. In example embodiments, the second power voltage VDD2 may be the same voltage as the first power voltage VDD1, or may be a different voltage than the first power voltage VDD1.

When the gain control transistor DRX is turned on by the gain control signal DRG, capacitance of the first floating diffusion node FD1 may increase, such that a conversion gain of the pixel group PG2 may decrease. Conversely, when the gain control transistor DRX is turned off, the conversion gain of the pixel group PG2 may increase.

The gate of the amplification transistor SF may be connected to the first floating diffusion node FD1, and the amplification transistor SF may be connected between the third power node and the select transistor SX. The third power node may be a node supplying the third power voltage VDD3. In example embodiments, the third power voltage VDD3 may be equal to at least one of the first power voltage VDD1 and the second power voltage VDD2. In an example embodiment, the third power voltage VDD3 may be equal to the second power voltage VDD2 and may be greater than the first power voltage VDD1. Also, in an example embodiment, the third power voltage VDD3 may be greater than the first power voltage VDD1 and the second power voltage VDD2.

The amplification transistor SF may operate as a source-follower amplifier and may generate a signal by amplifying the voltage of the first floating diffusion node FD1. The signal generated by the amplification transistor SF may be output to the column line COL by an operation of turning-on the select transistor SX. The column line COL may be connected to one of input terminals of the correlated double sampler, and the correlated double sampler may transfer a signal output by the column line COL and an output signal determined by the ramp voltage to the counter.

The operation of the pixel group PG2 may include a shutter operation, an exposure operation, and a readout operation. In the shutter operation, electric charges of the first and second floating diffusion nodes FD1 and FD2 and the first and second photodiodes PD1 and PD2 may be removed. In the exposure operation, the first and second photodiodes PD1 and PD2 may be exposed to light for a predetermined exposure time period and may generate electric charges.

In an example embodiment, electric charge generated in excess of the FWC of the second photodiode PD2 may be stored in the capacitor CAP, and electric charge generated in excess of the FWC of each of the first photodiodes PD1 may be released through the second power node. Accordingly, during the exposure time period, only electric charge generated in excess of the FWC of the second photodiode PD2 may be stored in the capacitor CAP.

In the readout operation, the voltage of the first floating diffusion node FD1 may be amplified and may be output to the column line COL, and for example, the reset voltage and the signal voltage may be output to the column line COL. The reset voltage may be output to the column line COL by the pixel circuit in the state in which the first floating diffusion node FD1 is reset, and the signal voltage may be output to the column line COL by the pixel circuit in the state in which at least a portion of electric charge generated by the photodiode PD is stored in the first floating diffusion node FD1.

In an example embodiment, the operation in which the pixel circuit outputs the voltage to the column line COL after one exposure time period may be executed two or more times. For example, the readout operation executed after one exposure time period may include a plurality of readout operations executed in sequence. In at least a portion of the plurality of readout operations, the conversion gain of the pixel group PG2 may be configured differently.

In an example embodiment, the readout operation may include an HCG readout operation executed under a condition in which the pixel group PG2 has a relatively large conversion gain, and an LCG readout operation executed under a condition in which pixel group PG2 has a relatively small conversion gain. Also, the readout operation may include an LOFIC readout operation of reading a voltage corresponding to electric charges generated by an overflow of the second photodiode PD2 during the exposure time period and stored in the capacitor CAP.

In an example embodiment, among the plurality of photodiodes PD1 and PD2 included in the pixel group PG2, only the second photodiode PD2 may be connected to the capacitor CAP. Accordingly, the amount of electric charge stored in the capacitor CAP during the exposure time period may be reduced, such that sensitivity of the readout operation of reading a voltage corresponding to electric charge stored in the capacitor may be improved.

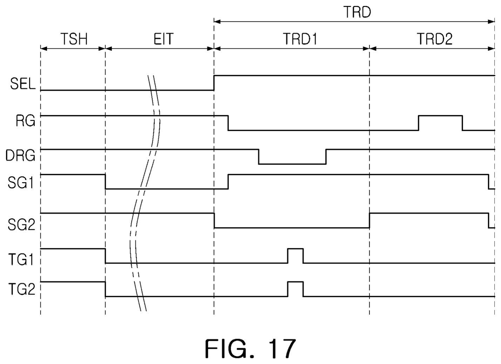

FIG. 17 is a diagram illustrating the operation of a pixel group according to the example embodiment illustrated in FIG. 16.

FIG. 17 is a timing diagram illustrating a shutter operation, exposure operation, and readout operation of one pixel group PG2. In the operation of pixel group PG2 described with reference to FIGS. 14 to 16, turning on/off of transistors SX, RX, DRX, SW1 and SW2, TX1, and TX2 included in the pixel group PG2 may be determined by control signals SEL, RG, DRG, SG1, SG2, TG1, and TG2 output by the row driver.

During the shutter operation time TSH of the pixel group PG2, the select transistor SX may be turned off, and the first transfer transistors TX1, the second transfer transistor TX2, the gain control transistor DRX, the reset transistor RX, the first switch transistor SW1, and the second switch transistor SW2 may be turned on. Accordingly, electric charge of the first photodiode PD1, the second photodiodes PD2, the first floating diffusion node FD1, the second floating diffusion node FD2, and the capacitor CAP may be removed by the first power voltage VDD1 and the second power voltage VDD2.

During the exposure time period EIT, the reset transistor RX, the gain control transistor DRX, and the second switch transistor SW2 may be turned on, and the other transistors SX, SW1, TX1, and TX2 may be turned off. The first photodiodes PD1 and the second photodiode PD2 may generate electric charges in response to light, and the generated electric charges may remain in the first photodiodes PD1 and the second photodiode PD2. However, in a circumstance in which relatively strong light is input, electric charges may be generated above the FWC of the first photodiodes PD1 and the second photodiode PD2. Hereinafter, for ease of description, electric charges generated above the FWC in each of the first photodiode PD1 and the second photodiode PD2 may be defined as excess electric charges.

When excess electric charge is generated by the first photodiode PD1, the voltage of the node at which the first transfer transistor TX1 and the first photodiode PD1 are connected to each other, for example, the source of the first transfer transistor TX1, may decrease due to the excess electric charge. Accordingly, even though the first transfer control signal TG1 input to a gate of the first transfer transistor TX1 may be maintained at a voltage corresponding to a logic low, a path for moving electric charge may be formed through a channel of the first transfer transistor TX1. The excess electric charge of the first photodiode PD1 may move to the first floating diffusion node FD1.

In this case, since the gain control signal DRG input to a gate of the gain control transistor DRX and the reset control signal RG input to a gate of the reset transistor RX are maintained at a voltage corresponding to a logic high, the excess electric charge of the first photodiode PD1 may be released to the second power node.

Also, in an example embodiment, when excess electric charge is generated by the second photodiode PD2, the voltage of the node at which the second transfer transistor TX and the second photodiode PD2 are connected to each other, for example, the source voltage of the second transfer transistor TX2, may decrease due to the excess electric charge. Accordingly, even though the second transfer control signal TG2 input to the gate of the second transfer transistor TX2 is maintained at a voltage corresponding to the logic low, a path for moving electric charge may be formed through the channel of the second transfer transistor TX2. The excess electric charge of the second photodiode PD2 may move to the second floating diffusion node FD2.

In an example embodiment, the voltage of the source voltage of the second switch transistor SW2 may decrease due to electric charge of the second floating diffusion node FD2. In addition, the second switch control signal SG2 input to the gate of the second switch transistor SW2 is maintained at a voltage corresponding to the logic high, so a path for moving electric charge may be formed through a channel of the second switch transistor SW2, and the excess electric charge moving to the second floating diffusion node FD2 may move to and may be stored in the capacitor CAP. Accordingly, during the exposure time period EIT, only the excess electric charge of the second photodiode PD2 may be stored in the capacitor CAP. The first switch transistor SW1 may be turned off such that the excess electric charge may not move to the first floating diffusion node FD1.

The pixel group PG2 may execute a readout operation after the exposure time period EIT has elapsed. The readout operation may include first and second readout operations. In the first readout operation, the pixel group PG2 may output a voltage corresponding to electric charge generated by the first and second photodiodes PD1 and PD2 under a high conversion gain condition and a low conversion gain condition, respectively. In the second readout operation, the pixel group PG2 may output a voltage corresponding to excess electric charge generated by the second photodiode PD2 and stored in the capacitor CAP.

Referring to FIG. 17, the reset voltage may be output twice. The first reset voltage may be output in a state in which the gain control transistor DRX is turned on, and the second reset voltage may be output in a state in which the gain control transistor DRX is turned off. The first reset voltage may be a reset voltage output under a condition in which the pixel group PG2 has a low conversion gain, and the second reset voltage may be a reset voltage output under a condition in which the pixel group PG2 has a high conversion gain.

Referring to FIG. 17, during the first readout time period TRD1, the select transistor SX may be turned on by the select control signal SEL, and the second switch transistor SW2 may be turned off by the second switch control signal SG2. Thereafter, the reset transistor RX may be turned off by the reset control signal RG, and the first switch transistor SW1 may be turned on by the first switch control signal SG1, and the amplification transistor SF may amplify the voltage of the first floating diffusion node FD1 and may output the first reset voltage.

When the first reset voltage is output (e.g., after the first reset voltage has been output), the gain control transistor DRX may be turned off by the gain control signal DRG, and the first node N1 and the first floating diffusion node FD1 may be isolated. Capacitance of the first floating diffusion node FD1 may be maintained relatively small, and the second reset voltage may be output under the condition in which the pixel group PG2 has a high conversion gain.

Thereafter, the first transfer transistors TX1 and the second transfer transistor TX2 are turned on, and electric charge of the first photodiodes PD1 and the second photodiode PD2 may move to the first floating diffusion node FD1. The amplification transistor SF may output the first signal voltage, which is the amplified voltage of the first floating diffusion node FD1, to the column line COL. Since the gain control transistor DRX maintains the turned-off state, the pixel group PG2 may output the first signal voltage under the condition of having a high conversion gain.

The readout circuit connected to the column line COL may derive the first pixel signal from a difference between the second reset voltage and the first signal voltage. The first pixel signal may be a signal for covering relatively low first range illuminance.

Referring to FIG. 17, while the pixel group PG2 outputs a first signal voltage to the column line COL, the gain control transistor DRX may be turned on by the gain control signal DRG. Accordingly, capacitance of the first floating diffusion node FD1 may be maintained large, and the second signal voltage may be output under the condition in which the pixel group PG2 has a low conversion gain.

The readout circuit connected to the column line COL may generate the second pixel signal from a difference between the first reset voltage and the second signal voltage. The second pixel signal may be a signal for covering illuminance of the second range higher than the first range.

Thereafter, during the second readout time period TRD2 of the pixel group PG2, the second switch transistor SW2 may be turned on, such that electric charge stored in the capacitor CAP may move to the first floating diffusion node FD1. Through the column line COL, the signal voltage corresponding to electric charge stored in the capacitor CAP may be output.

After the signal voltage is output, the row driver may turn on the reset transistor RX. Accordingly, a reset operation of removing electric charge of the first floating diffusion node FD1, the second floating diffusion node FD2, and the capacitor CAP may be executed, and the reset voltage may be output through the column line COL. The readout circuit may generate a third pixel signal using a difference between the reset voltage output by the pixel group PG2 and the signal voltage. The third pixel signal may be a signal for covering illuminance of the third range higher than the second range.

As described above, only the excess electric charge generated in excess of FWC in the second photodiode PD2 during the exposure time period EIT may be stored in the capacitor CAP. Electric charge may be stored in the capacitor CAP under the condition in which strong light generating electric charge in excess of FWC of the second photodiode PD2 enters the pixel group PG2. Accordingly, relatively high illuminance may be covered using the third pixel signal generated by electric charge stored in the capacitor CAP.

The first and second pixel signals may be generated by electric charge stored in nine photodiodes PD1 and PD2. Alternatively, the third pixel signal may be generated by the excess electric charge generated in excess of FWC of one second photodiode PD2. Compared to a general third pixel signal generated by the excess electric charge of nine photodiodes PD1 and PD2, sensitivity of the third pixel signal generated by the excess electric charge of one second photodiode PD2 in an example embodiment may provide about nine times improved sensitivity.

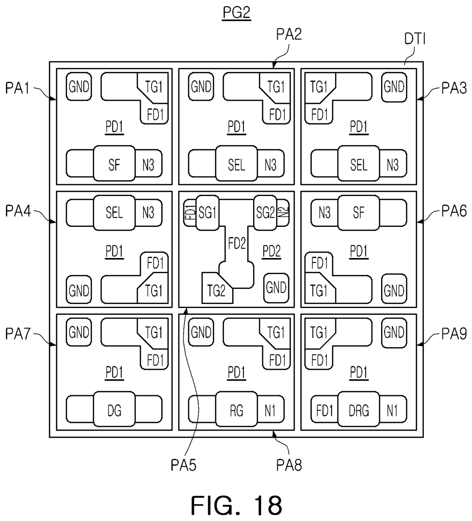

FIG. 18 is a diagram illustrating a layout of a pixel group according to the example embodiment illustrated in FIG. 16.

FIG. 18 illustrates an example layout of pixel group PG2 described with reference to FIGS. 14 to 16. First, referring to FIG. 18, the device isolation film DTI may be an insulating film for isolating the pixel groups PG2 from each other and isolating a plurality of photodiodes PD included in pixel group PG2 from each other. The pixel group PG2 may include a plurality of pixel regions PA1-PA9.

In an example embodiment illustrated in FIG. 18, the pixel group PG2 may include nine pixel regions PA1-PA9 disposed in a 3x3 structure, and each of the nine pixel regions PA1-PA9 may include a photodiode. Referring to FIGS. 14 to 16, the first photodiode PD1 may be disposed in each of the first to fourth pixel regions PA1-PA4 and the sixth to ninth pixel regions PA6-PA9. In the fifth pixel region PA5, the second photodiode PD2 may be disposed. In each of the first to ninth pixel regions PA1-PA9, a ground region GND to which a ground voltage is applied may be disposed.

In the first and sixth pixel regions PA1 and PA6, the gate TG1 of the first transfer transistor and the gate SF of the amplification transistor may be disposed. A high-concentration doping region of the gate TG1 around the first transfer transistor may be included in the first floating diffusion region FD1. The high-concentration doping regions disposed on both sides of the gate SF of the amplification transistor may be included in the amplification transistor. The region disposed on one side of the gate SF of the amplification transistor may be included in the third node region N3, and the third power voltage may be applied to the region disposed on the other side.

In each of the second to fourth pixel regions PA2-PA4, the gate TG1 of the first transfer transistor and the gate SEL of the select transistor may be disposed. A high-concentration doping region of the gate TG1 around the first transfer transistor may be included in the first floating diffusion region FD1. The gate SEL of the select transistor and the high-concentration doping regions disposed on both sides may be included in the select transistor. The region disposed on one side of may be included in the third node region N3, and the region disposed on the other side may be connected to the column line.

In the fifth pixel region PA5, the gate TG2 of the second transfer transistor, the gate SG1 of the first switch transistor, and the gate SG2 of the second switch transistor may be disposed. A high-concentration doping region between the gate TG2 of the second transfer transistor, the gate SG1 of the first switch transistor, and the gate SG2 of the second switch transistor may be included in the second floating diffusion region FD2. The high-concentration doping region disposed on one side of the gate SG1 of the first switch transistor may be included in the first floating diffusion region FD1. The high-concentration doping region disposed on one side of the gate SG2 of the second switch transistor may be included in the second node region N2.

In the seventh pixel region PA7, the gate TG1 of the first transfer transistor and the dummy gate DG may be disposed. The high-concentration doping region around the gate TG1 of the first transfer transistor may be included in the first floating diffusion region FD1. The dummy gate DG may be used to implement the operation properties of the pixel group PG2.

In the eighth pixel region PA8, the gate TG1 of the first transfer transistor and the gate RG of the reset transistor may be disposed. The high-concentration doping region of the gate TG1 around the first transfer transistor may be included in the first floating diffusion region FD1. The gate RG of the reset transistor and the high-concentration doping regions disposed on both sides may be included in the reset transistor. The region disposed on one side of the gate RG of the reset transistor may be included in the first node region N1, and the second power voltage may be applied to the region disposed on the other side.

In the ninth pixel region PA9, the gate TG1 of the first transfer transistor and the gate DRG of the gain control transistor may be disposed. The high-concentration doping region of the gate TG1 around the first transfer transistor may be included in the first floating diffusion region FD1. The gate DRG of the gain control transistor and the high-concentration doping regions disposed on both sides may be included in the gain control transistor. The region disposed on one side of the gate DRG of the gain control transistor may be included in the first node region N1, and the region disposed on the other side may be included in the first floating diffusion region FD1.

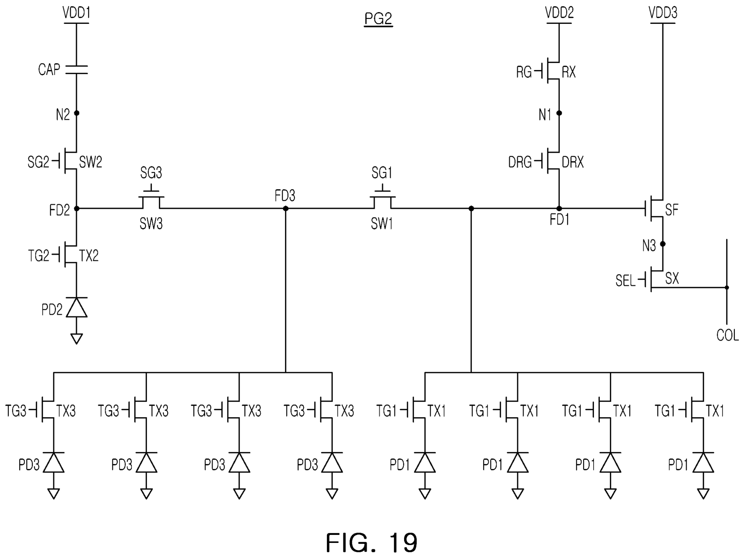

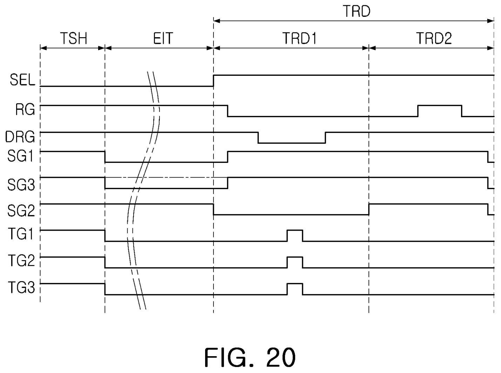

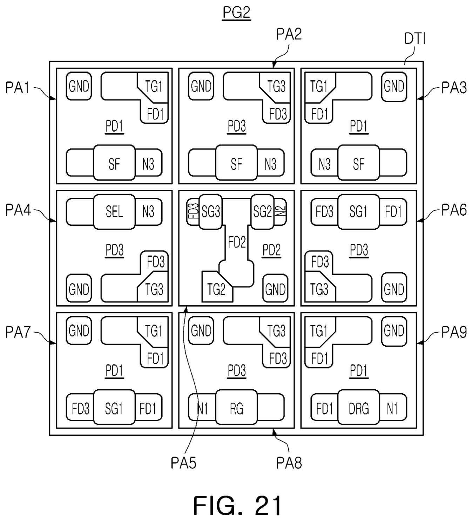

FIG. 19 is a circuit diagram illustrating a pixel group according to an example embodiment. FIG. 20 is a diagram illustrating operations of a pixel group according to the example embodiment illustrated in FIG. 19. FIG. 21 is a diagram illustrating the layout of a pixel group according to the example embodiment illustrated in FIG. 19.

FIG. 19 illustrates an example embodiment of the pixel group PG2 in FIGS. 14 and 15. In an example embodiment illustrated in FIG. 19, the pixel group PG2 included in the image sensor may include a plurality of photodiodes PD1, PD2, and PD3 and a pixel circuit. The plurality of photodiodes PD1, PD2, and PD3 may include at least one first photodiode PD1, at least one second photodiode PD2, and at least one third photodiode PD3.

According to an example embodiment illustrated in FIG. 19, four first photodiodes PD1 may be connected in parallel between a first floating diffusion node FD1 and a reference node. Four third photodiodes PD3 may be connected in parallel between a third floating diffusion node FD3 and a reference node. In this case, the reference node may be a ground node.

Comparing the pixel group PG2 in FIG. 16 with the pixel group PG2 in FIG. 19, the pixel group PG2 in FIG. 19 may further include third photodiodes PD3. In the description below, the difference will be mainly described.

First, referring to FIG. 19, the pixel group PG2 may further include the third photodiodes PD3. In an example embodiment illustrated in FIG. 19, the pixel group PG2 may include nine photodiodes. The pixel group PG2 may include four first photodiodes PD1, one second photodiode PD2, and four third photodiodes PD3. However, the number of first to third photodiodes may not be limited thereto. The sizes of the first to third photodiodes PD1-PD3 may be the same. Accordingly, light-receiving areas of the first to third photodiodes PD1-PD3 may be the same.

The pixel circuit may further include a third floating diffusion node FD3 connected to the third photodiodes PD3 through third transfer transistors TX3, and a third switch transistor SW3 connected between the second floating diffusion node FD2 and the third floating diffusion node FD3. In an example embodiment, the first switch transistor TX1 may be connected between the first floating diffusion node FD1 and the third floating diffusion node FD3. Control signals TG3 and SG3 controlling the third transfer transistors TX3 and the third switch transistor SW3 may be output by a row driver.

According to an example embodiment illustrated in FIG. 19, four third photodiodes PD3 may be connected in parallel between the third floating diffusion node FD3 and a reference node. In this case, the reference node may be a ground node.

At least one of the plurality of photodiodes PD1 and PD2 included in the pixel group PG2 may be electrically connected to the capacitor CAP. According to an example embodiment illustrated in FIG. 19, the first photodiode PD1 and/or the third photodiodes PD3 may be actively electrically connected to the capacitor CAP during the exposure time period.

Referring to FIGS. 19 and 20, the number of photodiodes PD actively electrically connected to the capacitor CAP during the exposure time period EIT may be controlled by controlling turning on/off of the third switch transistor SW3.

In an example embodiment, when the third switch control signal SG3 is maintained at a voltage corresponding to a logic low during the exposure time period EIT, the third photodiodes PD3 may not be actively electrically connected to the capacitor CAP. During the exposure time period EIT, only the excess electric charge of the second photodiode PD2 may be transferred to the second floating diffusion node FD2 and the capacitor CAP and may be stored therein. Accordingly, the pixel group PG2 in FIGS. 19 and 20 may operate in the same manner as the example embodiment described with reference to FIGS. 16 and 17 above.

In another example embodiment, when the third switch control signal SG3 is maintained at a voltage corresponding to a logic high during the exposure time period EIT, the third photodiodes PD3 may be electrically connected to the capacitor CAP. During the exposure time period EIT, when excess electric charge is generated by the second photodiode PD2 and the third photodiodes PD3, the voltage of the source of the second and third transfer transistors TX2 and TX3 may be reduced due to the excess electric charge. A path for moving electric charge may be formed through channels of the second and third transfer transistors TX2 and TX3, such that the excess electric charge of the second and third photodiodes PD2 and PD3 may move to the second floating diffusion node FD2.

The voltage of the source of the second switch transistor SW2 may decrease due to electric charge of the second floating diffusion node FD2. A path for moving electric charge may be formed through a channel of the second switch transistor SW2, and the excess electric charge moving to the second floating diffusion node FD2 may move to the capacitor CAP and may be stored. Accordingly, only the excess electric charge of the second and third photodiodes PD2 and PD3 may be stored in the capacitor CAP during the exposure time period EIT. The first switch transistor SW1 may be turned off such that the excess electric charge may not move to the first floating diffusion node FD1.

The pixel group PG2 may execute a readout operation after the exposure time period EIT has elapsed. The readout operation may include the first and second readout operations. In the first readout operation, the pixel group PG2 may output a voltage corresponding to electric charge generated by the first to third photodiodes PD1-PD3 under each of a high conversion gain condition and a low conversion gain condition. In the second readout operation, the pixel group PG2 may output a voltage corresponding to the excess electric charge generated by the second photodiode PD2 and/or the third photodiodes PD3 and stored in the capacitor CAP.

The pixel group PG2 in an example embodiment illustrated in FIGS. 19 and 20 may control the amount of excess electric charge stored in the capacitor CAP using turning on/off control of the third switch transistor SW3. The third pixel signal may be generated by the excess electric charge of one second photodiode PD2 and/or four third photodiodes PD3.

Comparing with the general third pixel signal generated by the excess electric charge of eight photodiodes PD1-PD3, sensitivity of the third pixel signal generated by the excess electric charge of one second photodiode PD2 in an example embodiment may provide about nine times improved sensitivity, and sensitivity of the third pixel signal generated by the excess electric charge of the five second and third photodiodes PD2 and PD3 in an example embodiment may provide about 1.8 times improved sensitivity.

Referring to FIG. 21, the first photodiode PD1 may be disposed in the first and third pixel regions PA1 and PA3. The gate TG1 of the first transfer transistor and the gate SF of the amplification transistor may be disposed in the first and third pixel regions PA1 and PA3. The high-concentration doping region of the gate TG1 around the first transfer transistor may be included in the first floating diffusion region FD1. The gate SF of the amplification transistor and the high-concentration doping regions disposed on both sides may be included in the amplification transistor. The region disposed on one side of the gate SF of the amplification transistor may be included in the third node region N3, and a third power voltage may be applied to the region disposed on the other side.

A third photodiode PD3 may be disposed in the second pixel region PA2. In the second pixel region PA2, the gate TG3 of the third transfer transistor and the gate SF of the amplification transistor may be disposed. The high-concentration doping region of the gate TG3 around the third transfer transistor may be included in the third floating diffusion region FD3. The high-concentration doping regions disposed on both sides of the gate SF of the amplification transistor may be included in the amplification transistor. The region disposed on one side of the gate SF of the amplification transistor may be included in the third node region N3, and the third power voltage may be applied to the region disposed on the other side.

A third photodiode PD3 may be disposed in the fourth pixel region PA4. In the fourth pixel region PA4, the gate TG3 of the third transfer transistor and the gate SEL of the select transistor may be disposed. The high-concentration doping region of the gate TG3 around the third transfer transistor may be included in the third floating diffusion region FD3. The high-concentration doping regions disposed on both sides of the gate SEL of the select transistor may be included in the select transistor. The region disposed on one side of the gate SEL of the select transistor may be included in the third node region N3, and the region disposed on the other side may be connected to the column line.

The second photodiode PD2 may be disposed in the fifth pixel region PA5. In the fifth pixel region PA5, the gate TG2 of the second transfer transistor, the gate SG2 of the second switch transistor, and the gate SG3 of the third switch transistor may be disposed. The high-concentration doping region between the gate TG2 of the second transfer transistor, the gate SG2 of the second switch transistor, and the gate SG3 of the third switch transistor may be included in the second floating diffusion region FD2. The high-concentration doping region disposed on one side of the gate SG2 of the second switch transistor may be included in the second node region N2. The high-concentration doping region disposed on one side of the gate SG3 of the third switch transistor may be included in the third floating diffusion region FD3.

The third photodiode PD3 may be disposed in the sixth pixel region PA6. In the sixth pixel region PA6, the gate TG3 of the third transfer transistor and the gate SG1 of the first switch transistor may be disposed. The high-concentration doping region of the gate TG3 around the third transfer transistor may be included in the third floating diffusion region FD3. The high-concentration doping regions disposed on both sides of the gate SG1 of the first switch transistor may be included in the first switch transistor. The region disposed on one side of the gate SG1 of the first switch transistor may be included in the first floating diffusion region FD1, and the region disposed on the other side may be included in the third floating diffusion region FD3.

The first photodiode PD1 may be disposed in the seventh pixel region PA7. In the seventh pixel region PA7, the gate TG1 of the first transfer transistor and the gate SG1 of the first switch transistor may be disposed. The high-concentration doping region of the gate TG1 around the first transfer transistor may be included in the first floating diffusion region FD1. The region disposed on one side of the gate SG1 of the first switch transistor may be included in the first floating diffusion region FD1, and the region disposed on the other side may be included in the third floating diffusion region FD3.

The third photodiode PD3 may be disposed in the eighth pixel region PA8. In the eighth pixel region PA8, the gate TG3 of the third transfer transistor and the gate RG of the reset transistor may be disposed. The high-concentration doping region of the gate TG3 around the third transfer transistor may be included in the third floating diffusion region FD3. The gate RG of the reset transistor and the high-concentration doping regions disposed on both sides may be included in the reset transistor. The region disposed on one side of the gate RG of the reset transistor may be included in the first node region N1, and the second power voltage may be applied to the region disposed on the other side.

The first photodiode PD1 may be disposed in the ninth pixel region PA9. The gate TG1 of the first transfer transistor and the gate DRG of the gain control transistor may be disposed in the ninth pixel region PA9. The high-concentration doping region of the gate TG1 around the first transfer transistor may be included in the first floating diffusion region FD1. The gate DRG of the gain control transistor and the high-concentration doping regions disposed on both sides may be included in the gain control transistor. The region disposed on one side of the gate DRG of the gain control transistor may be included in the first node region N1, and the region disposed on the other side may be included in the first floating diffusion region FD1.

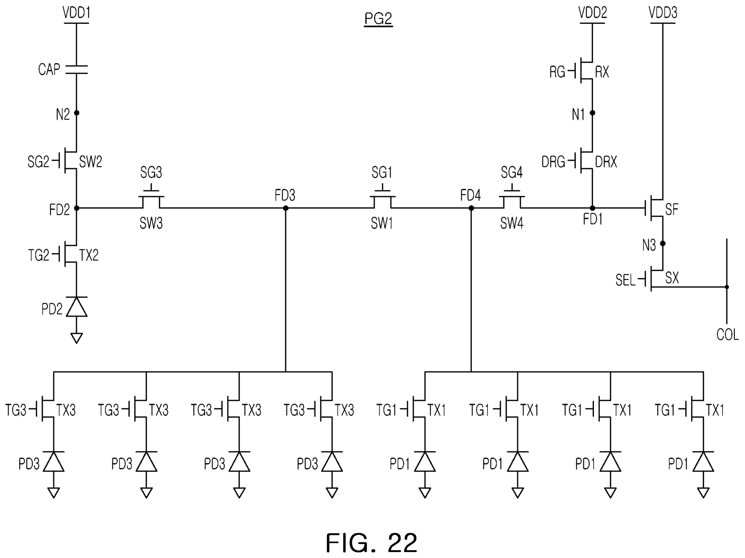

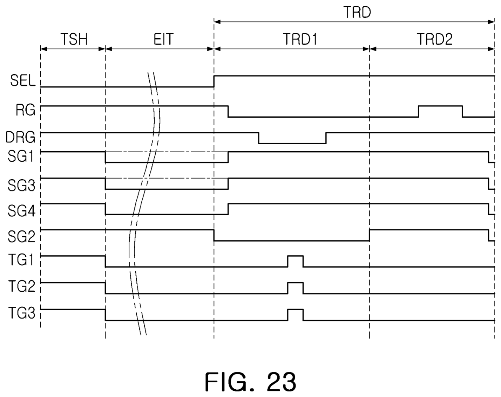

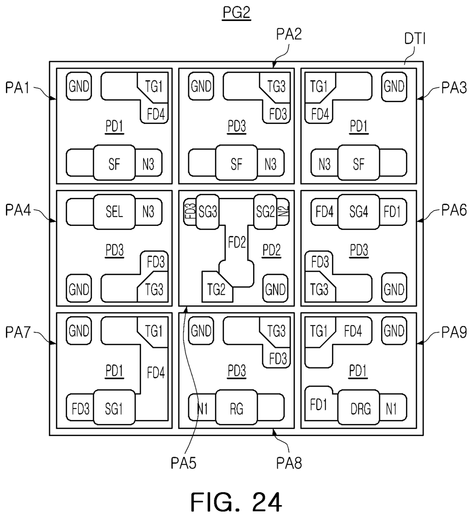

FIG. 22 is a circuit diagram illustrating a pixel group according to an example embodiment. FIG. 23 is a diagram illustrating operations of a pixel group according to the example embodiment illustrated in FIG. 22. FIG. 24 is a diagram illustrating a layout of a pixel group according to the example embodiment illustrated in FIG. 22.

FIG. 22 illustrates an example embodiment of the pixel group PG2 in FIGS. 14 and 15. In an example embodiment illustrated in FIG. 22, pixel group PG2 included in an image sensor may include a plurality of photodiodes PD1, PD2, and PD3 and a pixel circuit. The plurality of photodiodes PD1, PD2, and PD3 may include at least one first photodiode PD1, at least one second photodiode PD2, and at least one third photodiode PD3. Comparing the pixel group PG2 in FIG. 19 with the pixel group PG2 in FIG. 22, the pixel group PG2 in FIG. 22 may further include a fourth switch transistor SW4. The differences will be mainly described below.

Referring first to FIG. 22, the pixel group PG2 may further include a fourth switch transistor SW4 connected between a first switch transistor SW1 and a first floating diffusion node FD1. A fourth switch control signal SG4 controlling the fourth switch transistor SW4 may be output by a row driver.

Referring to FIG. 22 and FIG. 23, by controlling turning on/off of the first and third switch transistors SW1 and SW3, the number of photodiodes PD electrically connected to the capacitor CAP during the exposure time period EIT may be controlled.

In an example embodiment, when first and third switch control signals SG1 and SG3 are maintained at a voltage corresponding to a logic low during the exposure time period EIT, the first photodiode PD1 and the third photodiodes PD3 may not be actively electrically connected to the capacitor CAP. During the exposure time period EIT, only the excess electric charge of the second photodiode PD2 may be transferred to the second floating diffusion node FD2 and the capacitor CAP and may be stored therein. Accordingly, the pixel group PG2 in FIGS. 22 and 23 may operate in the same manner as in the example embodiment described with reference to FIGS. 16 and 17 above.

In another example embodiment, when the third switch control signal SG3 is maintained at a voltage corresponding to a logic high and the first switch control signal SG1 is maintained at a voltage corresponding to a logic low during the exposure time period EIT, the third photodiodes PD3 may be actively electrically connected to the capacitor CAP. The excess electric charge of the second photodiode PD2 and/or the third photodiodes PD3 generated during the exposure time period EIT may be transferred to the second floating diffusion node FD2 and the capacitor CAP and may be stored in the capacitor CAP. Accordingly, only the excess electric charge of the second photodiode PD2 and/or the third photodiodes PD3 may be stored in the capacitor CAP during the exposure time period EIT.

In another example embodiment, when the first and third switch control signals SG1 and SG3 are maintained at a voltage corresponding to a logic high during the exposure time period EIT, the first and third photodiodes PD2 and PD3 may be electrically connected to the capacitor CAP. The excess electric charge of the first to third photodiodes PD1-PD3 generated during the exposure time period EIT may move to the second floating diffusion node FD2 and the capacitor CAP and may be stored in the capacitor CAP. Accordingly, the excess electric charge of the first to third photodiodes PD1-PD3 may be stored in the capacitor CAP during the exposure time period EIT.

The pixel group PG2 may execute a readout operation after the exposure time period EIT has elapsed. The readout operation may include first and second readout operations. In the first readout operation, the pixel group PG2 may output a voltage corresponding to electric charge generated by the first to third photodiodes PD1-PD3 under each of a high conversion gain condition and a low conversion gain condition. In the second readout operation, the pixel group PG2 may output a voltage corresponding to the excess electric charge generated by at least one of the first to third photodiodes PD1-PD3 and stored in the capacitor CAP.

The pixel group PG2 in an example embodiment illustrated in FIGS. 22 and 23 may control the amount of excess electric charge stored in the capacitor CAP by controlling turning on/off of the first and third switch transistors SW1 and SW3. The third pixel signal may be generated by the excess electric charge of one second photodiode PD2 and/or four third photodiodes PD3 and/or four first photodiodes PD1.

Comparing with the general third pixel signal generated by the excess electric charge of nine photodiodes PD1-PD9, sensitivity of the third pixel signal generated by the excess electric charge of one second photodiode PD2 in an example embodiment may provide about nine times improved sensitivity, and sensitivity of the third pixel signal generated by the excess electric charge of five second and third photodiodes PD2 and PD3 in an example embodiment may provide about 1.8 times improved sensitivity. Also, sensitivity of the third pixel signal generated by the excess electric charge of nine first to third photodiodes PD1-PD3 in an example embodiment may provide the same sensitivity.

Comparing the layout of the pixel group PG2 in FIG. 21 with the layout of the pixel group PG2 in FIG. 24, the layouts of the first, third, sixth, seventh, and ninth pixel regions PA1, PA3, PA6, PA7, and PA9 may be different. In the description below, the differences between the first, third, sixth, seventh, and ninth pixel regions PA1, PA3, PA6, PA7, and PA9 will be described.

In the first and third pixel regions PA1 and PA3, the gate TG1 of the first transfer transistor and the gate SF of the amplification transistor may be disposed. A high-concentration doping region of the gate TG1 around the first transfer transistor may be included in the fourth floating diffusion region FD4. The high-concentration doping regions disposed on both sides of the gate SF of the amplification transistor may be included in the amplification transistor. The high-concentration doping region disposed on the other side of the gate SF of the amplification transistor may be included in the third node region N3, and the third power voltage may be applied to the region disposed on the other side.

In the sixth pixel region PA6, the gate TG3 of the third transfer transistor and the gate SG4 of the fourth switch transistor may be disposed. The high-concentration doping region of the gate TG3 around the third transfer transistor may be included in the third floating diffusion region FD3. The high-concentration doping regions disposed on both sides of the gate SG4 of the fourth switch transistor may be included in the fourth switch transistor. The region disposed on one side of the gate SG4 of the fourth switch transistor may be included in the first floating diffusion region FD1, and the region disposed on the other side may be included in the fourth floating diffusion region FD4.

In the seventh pixel region PA7, the gate TG1 of the first transfer transistor and the gate SG1 of the first switch transistor may be disposed. The high-concentration doping region between the gate TG1 of the first transfer transistor and the gate SG1 of the first switch transistor may be included in the fourth floating diffusion region FD4. The region disposed on one side of the gate SG1 of the first switch transistor may be included in the third floating diffusion region FD3.

In the ninth pixel region PA9, the gate TG1 of the first transfer transistor and the gate DRG of the gain control transistor may be disposed. The high-concentration doping region of the gate TG1 around the first transfer transistor may be included in the fourth floating diffusion region FD4. The gate DRG of the gain control transistor and the high-concentration doping regions disposed on both sides thereof may be included in the gain control transistor. The region disposed on one side of the gate DRG of the gain control transistor may be included in the first node region N1, and the region disposed on the other side may be included in the first floating diffusion region FD1.

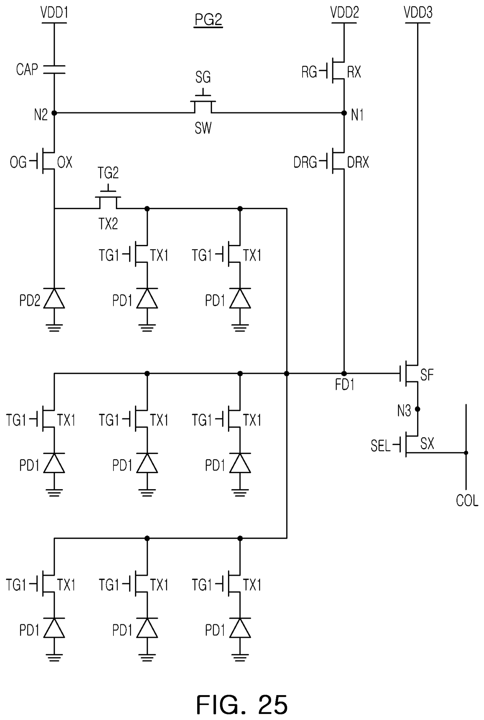

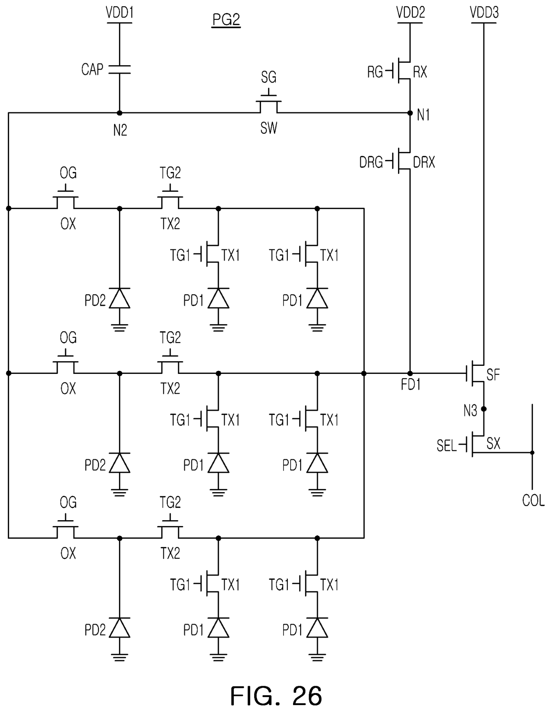

FIG. 25 is a circuit diagram illustrating a pixel group according to an example embodiment. FIG. 26 is a circuit diagram illustrating a pixel group according to an example embodiment.

Referring to FIG. 25 and FIG. 26, a pixel group PG2 included in an image sensor may include a plurality of photodiodes PD1 and PD2 and a pixel circuit. The plurality of photodiodes PD1 and PD2 may include at least one first photodiode PD1 and at least one second photodiode PD2. The pixel group PG2 may include nine photodiodes. The pixel group PG2 may include eight first photodiodes PD1 and one second photodiode PD2. However, the number of the first and second photodiodes may not be limited thereto.

The pixel circuit may include a first floating diffusion node FD1, first transfer transistors TX1, a second transfer transistor TX2, a gain control transistor DRX, a reset transistor RX, an amplification transistor SF, a select transistor SX, an overflow transistor OX, and a switch transistor SW. Control signals TG1, TG2, DRG, RG, SEL, OG, and SG for controlling a plurality of transistors included in a pixel circuit may be output by a row driver.

In the pixel circuits of pixel group PG2 according to an example embodiment, a capacitor CAP may be included. During the exposure time period, at least one of the plurality of photodiodes PD1 and PD2 included in the pixel group PG2 may be electrically connected to the capacitor CAP.

Comparing the pixel group PG2 in FIG. 16 with the pixel group PG2 in FIGS. 25 and 26, the pixel group PG2 in FIGS. 25 and 26 may not include first and second switch transistors SW1 and SW2, and may include an overflow transistor OX. Hereinafter, the differences will be described.

First, referring to FIG. 25, the overflow transistor OX may provide a path for moving excess electric charge generated above the FWC in the photodiode PD to the capacitor CAP. By controlling the magnitude of the voltage applied to the overflow gate TG, the amount of excess electric charge moving to the capacitor CAP may be controlled.

The first floating diffusion node FD1 may be connected to the first photodiodes PD1 through the first transfer transistors TX1. When the first transfer transistors TX1 are turned on by the first transfer control signal TG1, electric charge of the first photodiodes PD1 may be stored in the first floating diffusion node FD1.

The second transfer transistor TX2 may be connected between the first floating diffusion node FD1 and the second photodiode PD2. In an operation of transferring electric charge generated by the second photodiode PD2 to the first floating diffusion node FD1, the second transfer transistor TX2 may be turned on by the second transfer control signal TG2.

The capacitor CAP may be connected between the first power node and the overflow transistor OX. In an example embodiment illustrated in FIG. 25, the capacitor CAP may be connected between the first power node and the second node N2. The first power node may be a node supplying the first power voltage VDD1. The overflow transistor OX may provide a path for moving electric charge generated by the second photodiode PD2 to the capacitor CAP.

A reset transistor RX and a gain control transistor DRX may be connected to each other between the second power node and the first floating diffusion node FD1. In an example embodiment illustrated in FIG. 16, a reset transistor RX may be connected between the second power node and the first node N1, and a gain control transistor DRX may be connected between the first node N1 and the first floating diffusion node FD1. The second power node may be a node supplying the second power voltage VDD2. In example embodiments, the second power voltage VDD2 may be the same voltage as the first power voltage VDD1, or may be a different voltage than the first power voltage VDD1. A switch transistor SW may be connected between the first node N1 and the second node N2.

When the gain control transistor DRX is turned on by the gain control signal DRG, capacitance of the first floating diffusion node FD1 may increase, thereby decreasing a conversion gain of the pixel group PG2. Conversely, when the gain control transistor DRX is turned off, the conversion gain of the pixel group PG2 may increase.

The gate of the amplification transistor SF may be connected to the first floating diffusion node FD1, and the amplification transistor SF may be connected between the third power node and the select transistor SX. The third power node may be a node supplying the third power voltage VDD3. In example embodiments, the third power voltage VDD3 may be equal to at least one of the first power voltage VDD1 and the second power voltage VDD2. In an example embodiment, the third power voltage VDD3 may be equal to the second power voltage VDD2 and may be greater than the first power voltage VDD1. Also, in an example embodiment, the third power voltage VDD3 may be greater than the first power voltage VDD1 and the second power voltage VDD2.

The amplification transistor SF may operate as a source-follower amplifier and may generate a signal by amplifying the voltage of the first floating diffusion node FD1. The signal generated by the amplification transistor SF may be output to the column line COL by an operation of turning-on the select transistor SX. The column line COL may be connected to one of input terminals of the correlated double sampler, and the correlated double sampler may transfer the signal output by the column line COL and the output signal determined by the ramp voltage to the counter.

The operation of the pixel group PG2 may include a shutter operation, an exposure operation, and a readout operation. In the shutter operation, electric charge of the first floating diffusion node FD1 and the first and second photodiodes PD1 and PD2 may be removed. In the exposure operation, the first and second photodiodes PD1 and PD2 may be exposed to light for a predetermined exposure time period and may generate an electric charge.

In an example embodiment, electric charge generated in excess of the FWC of the second photodiode PD2 may be stored in the capacitor CAP, and electric charge generated in excess of the FWC of each of the first photodiodes PD1 may be released through the second power node. Accordingly, during the exposure time period, only electric charge generated in excess of the FWC of the second photodiode PD2 may be stored in the capacitor CAP.

In the readout operation, the voltage of the first floating diffusion node FD1 may be amplified and may be output to the column line COL, and for example, the reset voltage and the signal voltage may be output to the column line COL. The reset voltage may be output to the column line COL by the pixel circuit in the state in which the first floating diffusion node FD1 is reset, and the signal voltage may be output to the column line COL by the pixel circuit in the state in which at least a portion of electric charge generated by the photodiodes PD is stored in the first floating diffusion node FD1.

In an example embodiment, the operation in which the pixel circuit outputs the voltage to the column line COL after one exposure time period may be executed two or more times. For example, the readout operation executed after one exposure time period may include a plurality of readout operations executed in sequence. In at least a portion of the plurality of readout operations, the conversion gains of the pixel group PG2 may be configured differently.

In an example embodiment, the readout operation may include an HCG readout operation executed under a condition in which pixel group PG2 has a relatively large conversion gain, and an LCG readout operation executed under a condition in which pixel group PG2 has a relatively small conversion gain. Also, the readout operation may include an LOFIC readout operation of reading a voltage corresponding to electric charges generated by an overflow of the second photodiode PD2 during the exposure time period and stored in the capacitor CAP. In this case, the switch transistor SW may be turned on by the switch control signal SG.

In an example embodiment, among the plurality of photodiodes PD1 and PD2 included in the pixel group PG2, only one second photodiode PD2 may be connected to the capacitor CAP. Accordingly, the amount of electric charge stored in the capacitor CAP during the exposure time period may be reduced, and sensitivity of the readout operation of reading a voltage corresponding to electric charge stored in the capacitor may be improved.

Comparing the pixel group PG2 in FIG. 26 with the pixel group PG2 in FIG. 25, the number of the overflow transistors OX and the second transfer transistor TX2 may be different. The pixel group PG2 in FIG. 26 may include three overflow transistors OX and three second transfer transistors TX2.

According to an example embodiment illustrated in FIG. 26, two first photodiodes PD1 may be connected in parallel between the first floating diffusion node FD1 and the reference node. In this case, the reference node may be a ground node.

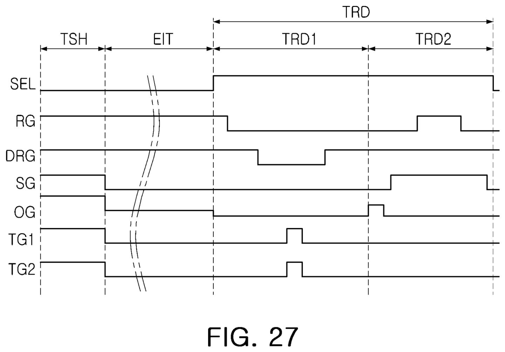

FIG. 27 is a diagram illustrating operations of a pixel group according to the example embodiment illustrated in FIG. 25.

FIG. 27 illustrates a shutter operation, an exposure operation, and a readout operation of one pixel group PG2. Referring to FIG. 25 and FIG. 26, in the pixel group PG2 described, turning on/off of each of the transistors TX1, TX2, DRX, RX, SX, OX, and SW included in the pixel group PG2 may be determined by the control signals TG1, TG2, DRG, RG, SEL, OG, and SG output by the row driver.

During the shutter operation time TSH of the pixel group PG2, the select transistor SX may be turned off, and the first transfer transistors TX1, the second transfer transistor TX2, the gain control transistor DRX, the reset transistor RX, the overflow transistor OX, and the switch transistor SW may be turned on. Accordingly, electric charge of the first photodiodes PD1, the second photodiode PD2, the first floating diffusion node FD1, and the capacitor CAP may be removed by the first power voltage VDD1 and the second power voltage VDD2.

During the exposure time period EIT, the reset transistor RX, the gain control transistor DRX, the second switch transistor SW2, and the overflow transistor OX are turned on, and the other transistors SX, SW, TX1, and TX2 may be turned off. The first photodiodes PD1 and the second photodiode PD2 may generate electric charge in response to light, and the generated electric charge may remain in the first photodiodes PD1 and the second photodiode PD2. However, in a circumstance in which relatively strong light is input, electric charge may be generated above the FWC of the first photodiodes PD1 and the second photodiode PD2. Hereinafter, for ease of description, electric charge generated above the FWC in each of the first photodiode PD1 and the second photodiode PD2 may be defined as excess electric charge.

When excess electric charge is generated by the first photodiode PD1, the voltage of the node at which the first transfer transistors TX1 and the first photodiodes PD1 are connected to each other, for example, the voltage of the source of each first transfer transistor TX1, may decrease due to the excess electric charge. Accordingly, even though the first transfer control signal TG1 input to the gate of the first transfer transistors TX1 is maintained at a voltage corresponding to a logic low, a path for moving electric charge may be formed through the channel of the first transfer transistors TX1. The excess electric charge of the first photodiodes PD1 may move to the first floating diffusion node FD1.

In this case, since the gain control signal DRG input to the gate of the gain control transistor DRX and the reset control signal RG input to the gate of the reset transistor RX are maintained at a voltage corresponding to a logic high, the excess electric charge of the first photodiode PD1 may be discharged to the second power node.

Also, as an example embodiment, when excess electric charge is generated by the second photodiode PD2, since the overflow control signal OG input to the gate of the overflow transistor OX is maintained at a voltage corresponding to a logic middle, a path for moving electric charge may be formed through the overflow transistor OX. The excess electric charge of the second photodiode PD2 may move to the second node N2. The excess electric charge moving to the second node N2 may move to the capacitor CAP and may be stored. Accordingly, only the excess electric charge of the second photodiode PD2 may be stored in the capacitor CAP during the exposure time period EIT.

The second transfer transistor TX2 may be turned off such that excess electric charge may not move to the first floating diffusion node FD1. Also, the switch transistor SW may be turned off such that excess electric charge may not move to the first node N1.

The pixel group PG2 may execute a readout operation after the exposure time period EIT has elapsed. The readout operation may include the first and second readout operations. In the first readout operation, the pixel group PG2 may output a voltage corresponding to electric charge generated by the first and second photodiodes PD1 and PD2 under each of a high conversion gain condition and a low conversion gain condition. In the second readout operation, the pixel group PG2 may output a voltage corresponding to the excess electric charge generated by the second photodiode PD2 and stored in the capacitor CAP.

Referring to FIG. 27, the reset voltage may be output twice. The first reset voltage may be output in a state in which the gain control transistor DRX is turned on, and the second reset voltage may be output in a state in which the gain control transistor DRX is turned off. The first reset voltage may be a reset voltage output when the pixel group PG2 has a low conversion gain, and the second reset voltage may be a reset voltage output when the pixel group PG2 has a high conversion gain.

Referring to FIG. 27, during the first readout time period TRD1, the select transistor SX may be turned on by the select control signal SEL, and the second switch transistor SW2 may be turned off by the second switch control signal SG2. Thereafter, the reset transistor RX may be turned off by the reset control signal RG, and the first switch transistor SW1 may be turned on by the first switch control signal SG1, and the amplification transistor SF may amplify the voltage of the first floating diffusion node FD1 and may output the first reset voltage.

When the first reset voltage is output, the gain control transistor DRX may be turned off by the gain control signal DRG, and the first node N1 and the first floating diffusion node FD1 may be isolated. Capacitance of the first floating diffusion node FD1 may be maintained relatively small, and the second reset voltage may be output under the condition in which the pixel group PG2 has a high conversion gain.

Thereafter, the first transfer transistor TX1 and the second transfer transistor TX2 may be turned on, and electric charge of the first photodiode PD1 and the second photodiode PD2 may move to the first floating diffusion node FD1. The amplification transistor SF may output the first signal voltage, which is the amplified voltage of the first floating diffusion node FD1, to the column line COL. Since the gain control transistor DRX maintains the turned-off state, the pixel group PG2 may output the first signal voltage under the condition of having a high conversion gain.

The readout circuit connected to the column line COL may derive the first pixel signal from a difference between the second reset voltage and the first signal voltage. The first pixel signal may be a signal for covering relatively low first range illuminance.

Referring to FIG. 27, while the pixel group PG2 outputs the first signal voltage to the column line COL, the gain control transistor DRX may be turned on by the gain control signal DRG. Accordingly, capacitance of the first floating diffusion node FD1 may be maintained large, and the second signal voltage may be output under the condition in which the pixel group PG2 has a low conversion gain.

The readout circuit connected to the column line COL may generate the second pixel signal from a difference between the first reset voltage and the second signal voltage. The second pixel signal may be a signal for covering illuminance of the second range higher than the first range.

Thereafter, during the second readout time period TRD2 of the pixel group PG2, the switch transistor SW may be turned on, such that electric charge stored in the capacitor CAP may move to the first floating diffusion node FD1. Through the column line COL, the signal voltage corresponding to electric charge stored in the capacitor CAP may be output.

When the signal voltage is output, the row driver may turn on the reset transistor RX. Accordingly, a reset operation of removing electric charge of the first floating diffusion node FD1 and the capacitor CAP may be executed, and the reset voltage may be output through the column line COL. The readout circuit may generate a third pixel signal using the difference between the reset voltage output by the pixel group PG2 and the signal voltage. The third pixel signal may be a signal for covering illuminance of the third range higher than the second range.

As described above, only the excess electric charge generated in excess of FWC in the second photodiode PD2 during the exposure time period EIT may be stored in the capacitor CAP. Electric charge may be stored in the capacitor CAP under the condition in which strong light generating electric charge in excess of FWC of the second photodiode PD2 enters the pixel group PG2. Accordingly, relatively high illuminance may be covered using the third pixel signal generated by electric charge stored in the capacitor CAP.

The timing diagram illustrating an example embodiment illustrated in FIG. 27 may be equally applied to the pixel group PG2 in the example embodiment illustrated in FIG. 26.

The first and second pixel signals may be generated by electric charges stored in nine photodiodes PD1 and PD2. Alternatively, the third pixel signal may be generated in excess of electric charge generated above the FWC of one second photodiode PD2.

According to an example embodiment illustrated in FIG. 25, the third pixel signal may be generated by the excess electric charge generated above the FWC of one second photodiode PD2. According to an example embodiment illustrated in FIG. 26, the third pixel signal may be generated by the excess electric charge generated above the FWC of three second photodiodes PD2. Accordingly, sensitivity of the LOFIC readout operation in the example embodiment illustrated in FIG. 25 may be improved three times as compared to sensitivity of the LOFIC readout operation in the example embodiment illustrated in FIG. 26.

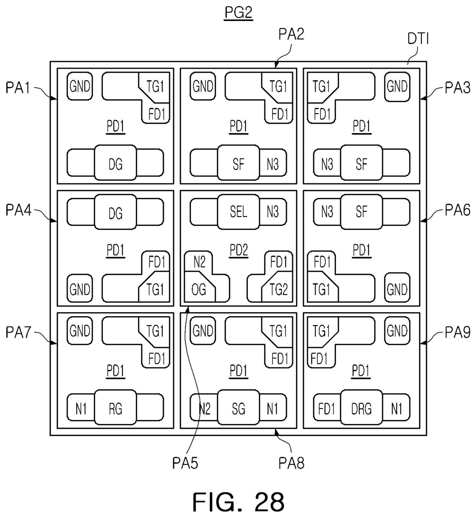

FIG. 28 is a diagram illustrating a layout of a pixel group according to the example embodiment illustrated in FIG. 25.

Referring to FIG. 28, a device isolation film DTI may be an insulating film for isolating pixel groups PG2 from each other and isolating a plurality of photodiodes PD included in the pixel group PG2 from each other. The pixel group PG2 may include a plurality of pixel regions PA1-PA9.

In an example embodiment illustrated in FIG. 28, the pixel group PG2 may include nine pixel regions PA1-PA9 disposed in a 3x3 structure, and each of the nine pixel regions PA1-PA9 may include a photodiode. Referring to FIG. 28, the first photodiode PD1 may be disposed in each of the first to fourth pixel regions PA1-PA4 and the sixth to ninth pixel regions PA6-PA9. The second photodiode PD2 may be disposed in the fifth pixel region PA5. In each of the first to ninth pixel regions PA1-PA9, a ground region GND to which a ground voltage is applied may be disposed.

In the first and fourth pixel regions PA1 and PA4, the gate TG1 of the first transfer transistor and the dummy gate DG may be disposed. The high-concentration doping region of the gate TG1 around the first transfer transistor may be included in the first floating diffusion region FD1.

In each of the second, third, and sixth pixel regions PA2, PA3, and PA6, the gate TG1 of the first transfer transistor and the gate SF of the amplification transistor may be disposed. A high-concentration doping region of the gate TG1 around the first transfer transistor may be included in the first floating diffusion region FD1. The gate SF of the amplification transistor and the high-concentration doping regions disposed on both sides may be included in the amplification transistor. The region disposed on one side of the gate SF of the amplification transistor may be included in the third node region N3, and the third power voltage may be applied to the region disposed on the other side.

In the fifth pixel region PA5, the gate TG2 of the second transfer transistor, the gate OG of the overflow transistor, and the gate SEL of the select transistor may be disposed. A high-concentration doping region of the gate TG2 around the second transfer transistor may be included in the first floating diffusion region FD1. A high-concentration doping region of the gate OG around the overflow transistor may be included in the second node region N2. The high-concentration doping regions disposed on both sides of the gate SEL of the select transistor may be included in the select transistor. The region disposed on one side of the gate SEL of the select transistor may be included in the third node region N3, and the region disposed on the other side may be connected to the column line.

In the seventh pixel region PA7, the gate TG1 of the first transfer transistor and the gate RG of the reset transistor may be disposed. The high-concentration doping region of the gate TG1 around the first transfer transistor may be included in the first floating diffusion region FD1. The gate RG of the reset transistor and the high-concentration doping regions disposed on both sides may be included in the reset transistor. The region disposed on one side of the gate RG of the reset transistor may be included in the first node region N1, and the second power voltage may be applied to the region disposed on the other side.

In the eighth pixel region PA8, the gate TG1 of the first transfer transistor and the gate SG of the switch transistor may be disposed. The high-concentration doping region of the gate TG1 around the first transfer transistor may be included in the first floating diffusion region FD1. The gate SG of the switch transistor and the high-concentration doping regions disposed on both sides may be included in the switch transistor. The region disposed on one side of the gate SG of the switch transistor may be included in the first node region N1, and the region disposed on the other side may be included in the second node region N2.

In the ninth pixel region PA9, the gate TG1 of the first transfer transistor and the gate DRG of the gain control transistor may be disposed. The high-concentration doping region of the gate TG1 around the first transfer transistor may be included in the first floating diffusion region FD1. The gate DRG of the gain control transistor and the high-concentration doping regions disposed on both sides may be included in the gain control transistor. The region disposed on one side of the gate DRG of the gain control transistor may be included in the first node region N1, and the region disposed on the other side may be included in the first floating diffusion region FD1.

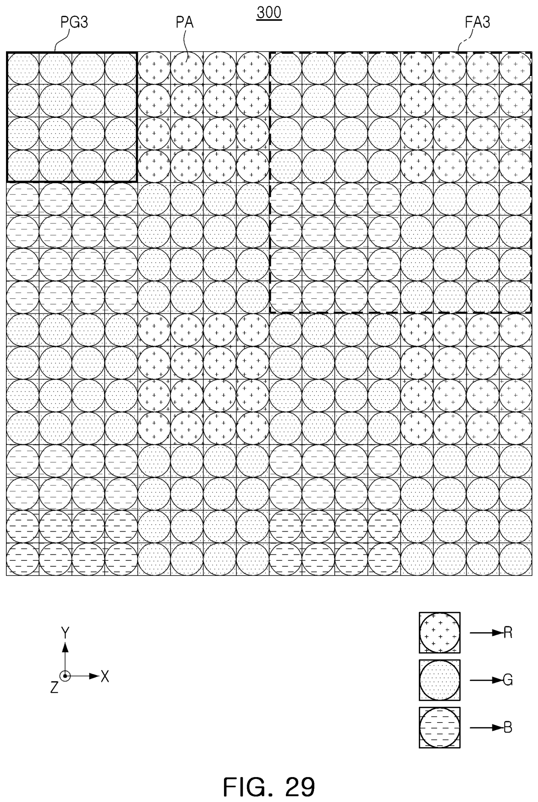

FIG. 29 is a diagram illustrating a pixel array structure of an image sensor according to an example embodiment.

Referring to FIG. 29, a pixel array 300 of an image sensor according to an example embodiment may include a plurality of pixel groups PG3 arranged in a first direction (X-axis direction) and a second direction (Y-axis direction). Each of the plurality of pixel groups PG3 may include pixel regions PA.

The pixel array 300 according to an example embodiment may include a color filter having an array generating an image having a hexa pattern. In an example embodiment illustrated in FIG. 29, the pixel array 300 may have an 8x8 hexa color filter array FA3 in which each of red, green, and blue are disposed in a 4x4 form. Each of the plurality of pixel groups PG3 may include 4x4 pixel regions PA. For example, 4x4 PD regions PA included in the plurality of pixel groups PG4 may include the same color filter. However, the array of color filters may not be limited thereto.

In an example embodiment illustrated in FIG. 29, each of the plurality of pixel groups PG3 may include one capacitor and 16 photodiodes. According to an example embodiment, sensitivity of the LOFIC readout operation may be controlled by controlling the number of photodiodes connected to a capacitor in each of the plurality of pixel groups PG3.

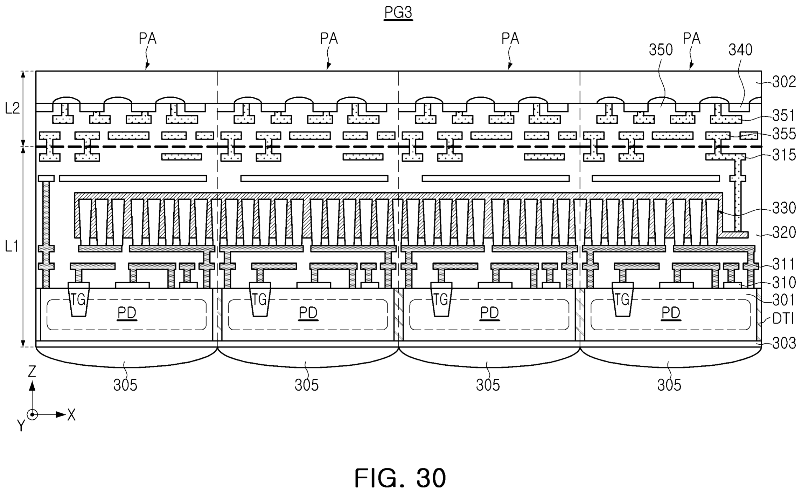

FIG. 30 is a diagram illustrating a structure of a pixel group included in an image sensor according to an example embodiment.

The pixel group PG3 illustrated in FIG. 30 illustrates a cross-section of the pixel group PG3 of the pixel array 300 illustrated in FIG. 29. For example, FIG. 30 is a diagram illustrating a cross-section of four PD regions PA arranged in the first direction in the pixel group PG3 in FIG. 29.

Comparing the pixel group PG3 in FIG. 30 with the pixel group PG2 in FIG. 15, the pixel group PG3 in FIG. 30 may further include one pixel region PA. Other specific example embodiments may be similar to the examples described with reference to FIG. 15.

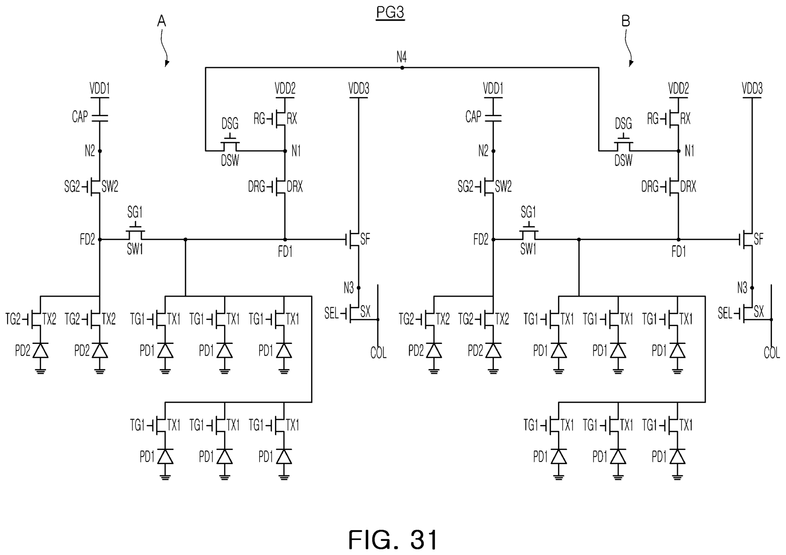

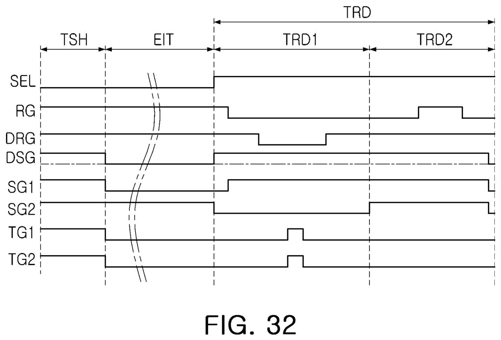

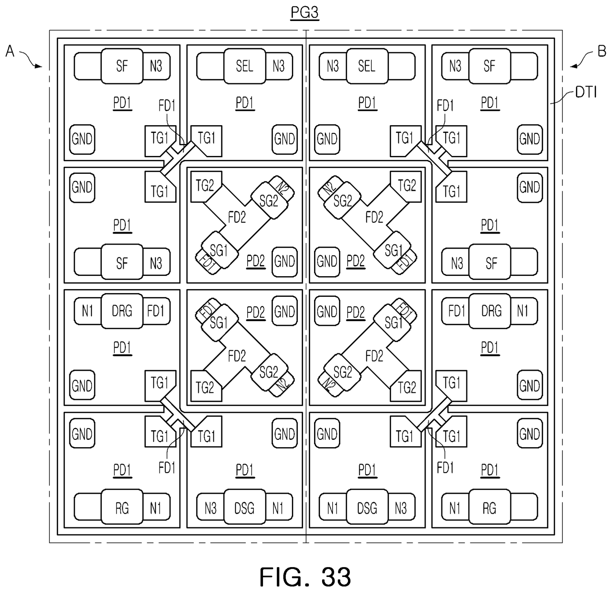

FIG. 31 is a circuit diagram illustrating a pixel group according to an example embodiment. FIG. 32 is a diagram illustrating operations of a pixel group according to the example embodiment illustrated in FIG. 31. FIG. 33 is a diagram illustrating a layout of a pixel group according to the example embodiment illustrated in FIG. 31.

Referring to FIG. 31, the pixel group PG3 may include 16 photodiodes. The pixel group PG3 may include 12 first photodiodes PD1 and 4 second photodiodes PD2. However, the number of first and second photodiodes may not be limited thereto.

The pixel group PG3 may include a first sub-pixel group A and a second sub-pixel group B. Each of the first and second sub-pixel groups A and B may include a plurality of photodiodes PD and pixel circuits. Each of the first and second sub-pixel groups A and B may include six first photodiodes PD1 and two second photodiodes PD2.

According to an example embodiment illustrated in FIG. 31, the six first photodiodes PD1 may be connected in parallel between the first floating diffusion node FD1 and the reference node. The two second photodiodes PD2 may be connected in parallel between the second floating diffusion node FD2 and the reference node. In this case, the reference node may be a ground node.

A pixel circuit of each of the first and second sub-pixel groups A and B may include a first floating diffusion node FD1, a second floating diffusion node FD2, first transfer transistors TX1, second transfer transistors TX2, a gain control transistor DRX, a reset transistor RX, an amplification transistor SF, a select transistor SX, a first switch transistor SW1, a second switch transistor SW2, and a capacitor CAP.

Each of the first and second sub-pixel groups A and B may be similar to the example of the pixel group PG2 in the circuit diagram described with reference to FIG. 16 above. However, the number of the first/second photodiodes and the first/second transfer transistors may be different. Also, each of the first and second sub-pixel groups A and B in the example embodiment illustrated in FIG. 31 may be different in that the sub-pixel groups include a dual switch transistor DSW.

Referring to FIGS. 31 and 32, an operation of each of the first and second sub-pixel groups A and B may be similar to the specific example embodiments described above with reference to FIG. 16.

In an example embodiment, a dual switch control signal DSG input to a gate of a dual switch transistor DSW may be maintained at a voltage corresponding to a logic low during a shutter operation time TSH to a readout time period TRD. The first and second sub-pixel groups A and B may operate independently. The first and second sub-pixel groups A and B may operate simultaneously or with a predetermined time difference. The operation of each of the first and second sub-pixel groups A and B may be similar to the specific example embodiments described above with reference to FIG. 16. A readout circuit connected to the column line COL may average signals of each of the first and second sub-pixel groups A and B and may produce first to third pixel signals.

In another example embodiment, the dual switch control signal DSG input to the gate of the dual switch transistor DSW may be maintained at a voltage corresponding to a logic high during the shutter operation time TSH and the readout time period TRD. The first and second sub-pixel groups A and B may operate simultaneously. The operation of each of the first and second sub-pixel groups A and B may be similar to the specific example embodiments described above with reference to FIG. 16.

During the readout time period TRD in which the dual switch control signal DSG input to the gate of the dual switch transistor DSW is maintained as a logic high, the first and second sub-pixel groups A and B may share the first floating diffusion region FD1. Accordingly, the readout circuit connected to the column line COL may generate the reset signal and the voltage signal without computation. For example, the first reset signal and the second voltage signal at the first readout time period TRD1, and the reset signal and voltage signal at the second readout time period TRD2 may be generated without computation for signals of the first and second sub-pixel groups A and B.

During the readout time period TRD, when the dual switch control signal DSG input to the gate of the dual switch transistor DSW is maintained as a logic low, the readout circuit connected to the column line COL may generate the reset and voltage signals by averaging the signals of the first and second sub-pixel groups A and B. For example, the second reset signal and the first voltage signal during the first readout time period TRD1 may be generated by averaging the signals of the first and second sub-pixel groups A and B.

Referring to FIG. 33, the layout of the first sub-pixel group A and the layout of the second sub-pixel group B may be symmetrical. However, an example embodiment thereof is not limited thereto.

Referring to the layout of the first sub-pixel group A, each of the plurality of pixel regions may include a photodiode and at least one transistor. In the four pixel regions disposed in a 2x2 structure, the pixel regions including the first photodiode PD1 may share the first floating diffusion region FD1. Specific example embodiments thereof may be similar to the examples described above in FIG. 7.

Specific example embodiments in the circuit diagram illustrating the pixel group PG3 and operation thereof illustrated in FIGS. 29 and 30 may be applied to the example embodiments of the pixel group PG2 described with reference to FIGS. 2 to 13 and/or the example embodiments of the pixel group PG3 described with reference to FIGS. 14 to 28. Also, the structure of the pixel array and the pixel group may not be limited to FIGS. 2 to 33.

According to the aforementioned example embodiments, by disposing a switch transistor in a circuit with at least one of the plurality of photodiodes connected to each other in parallel and controlling turning on/off of the switch transistor, the number of photodiodes actively electrically connected to a capacitor of each of the plurality of pixel groups may be controlled during the exposure time period, such that sensitivity of the readout operation of reading the voltage corresponding to electric charge stored in the capacitor may be selectively controlled.

While the example embodiments have been illustrated and described above, it will be configured as apparent to those skilled in the art that modifications and variations could be made without departing from the scope of the present disclosure.

Embodiments are set out in the following clauses:
Clause 1. An image sensor, comprising:
   a pixel array including a plurality of pixel groups arranged in a first direction and a second direction intersecting the first direction; and
   a peripheral circuit connected to the plurality of pixel groups by a plurality of row lines and a plurality of column lines, and configured to drive the plurality of pixel groups,
   wherein each of the plurality of pixel groups includes at least a first primary photodiode, at least a first secondary photodiode, and a pixel circuit connecting the first primary photodiode and the first secondary photodiode to the peripheral circuit,
   wherein the pixel circuit includes a capacitor configured to store at least a portion of electric charges generated by the first secondary photodiode during an exposure time period,
   wherein the peripheral circuit is configured to obtain a first pixel signal and a second pixel signal by executing a first readout operation for each of the plurality of pixel groups after the exposure time period, obtain a third pixel signal corresponding to electric charges stored in the capacitor by executing a second readout operation, and generate image data using the first pixel signal, the second pixel signal, and the third pixel signal, and
   wherein the first pixel signal is a signal output by each of the plurality of pixel groups under a high conversion gain condition, and the second pixel signal is a signal output by each of the plurality of pixel groups under a low conversion gain condition.
Clause 2. The image sensor of clause 1,
   wherein the pixel circuit includes a first floating diffusion node, a first primary transfer transistor connected between the first floating diffusion node and the first primary photodiode, a first switch transistor connected between the first floating diffusion node and a second floating diffusion node, a second switch transistor and a capacitor connected to the second floating diffusion node and connected to each other in series, a first secondary transfer transistor connected between the second floating diffusion node and the first secondary photodiode, and a gain control transistor connected to the first floating diffusion node, and
   wherein the peripheral circuit is configured to turn off the gain control transistor to select the high conversion gain condition, and turns on the gain control transistor to select the low conversion gain condition.
Clause 3. The image sensor of clause 2,
   wherein each of the plurality of pixel groups further includes at least a first tertiary photodiode, and
   wherein the pixel circuit further includes a third floating diffusion node connected to the first tertiary photodiode by a first tertiary transfer transistor, and a third switch transistor connected between the second floating diffusion node and the third floating diffusion node, and the first switch transistor is connected between the first floating diffusion node and the third floating diffusion node.
Clause 4. The image sensor of clause 3,
   wherein, in the first readout operation, each of the plurality of pixel groups outputs a voltage corresponding to electric charges generated by the first primary photodiode, the first secondary photodiode, and the first tertiary photodiode under each of the high conversion gain condition and the low conversion gain condition, and
   wherein, in the second readout operation, each of the plurality of pixel groups outputs a voltage corresponding to electric charges generated by at least one of the first primary photodiode, the first secondary photodiode and the first tertiary photodiode and stored in the capacitor.
Clause 5. An image sensor, comprising:
   a plurality of pixel groups arranged in a first direction and a second direction intersecting the first direction; and
   a peripheral circuit connected to the plurality of pixel groups by a plurality of row lines and a plurality of column lines, and configured to drive the plurality of pixel groups,
   wherein each of the plurality of pixel groups includes at least a first primary photodiode, at least a first secondary photodiode, and a pixel circuit connecting the first primary photodiode and the first secondary photodiode to the peripheral circuit,
   wherein the pixel circuit includes a first floating diffusion node, a first transfer transistor connected between the first floating diffusion node and the first primary photodiode, a first switch transistor connected between the first floating diffusion node and a second floating diffusion node, a second switch transistor and a capacitor connected to the second floating diffusion node and connected to each other in series, and a first secondary transfer transistor connected between the second floating diffusion node and the first secondary photodiode, and
   wherein the capacitor is configured to store at least a portion of electric charges generated by the first secondary photodiode without storing electric charges generated by the first primary photodiode during an exposure time period.

## Claims

1. An image sensor (10), comprising:
a pixel array (100) including a plurality of pixel groups (PG1),
wherein each of the plurality of pixel groups (PG1) includes a plurality of PD (photodiode) regions (PA) arranged in a first direction (X) and a second direction (Y) intersecting the first direction (X),
wherein each of the plurality of pixel groups (PG1) includes a plurality of photodiodes disposed in the plurality of PD regions (PA) and a pixel circuit configured to output a signal corresponding to electric charges generated by at least one of the plurality of photodiodes,
wherein the plurality of photodiodes include at least a first primary photodiode (PD1) and at least a first secondary photodiode (PD2), and
wherein the pixel circuit includes a first floating diffusion node (FD1) connected to the first primary photodiode (PD1) by a first primary transfer transistor (TX1), a second floating diffusion node (FD2) connected to the first secondary photodiode (PD2) by a first secondary transfer transistor (TX2), a first switch transistor (SW1) connected between the first floating diffusion node (FD1) and the second floating diffusion node (FD2), a reset transistor (RX) and a gain control transistor (DRX) connected between a second power node (VDD2) and the first floating diffusion node (FD1) in series, a capacitor (CAP) and a second switch transistor (SW2) connected in series with each other between a first power node (VDD1) and a second floating diffusion node (FD2), an amplification transistor (SF) having a gate connected to the first floating diffusion node (FD1) and connected to a third power node (VDD3), and a select transistor (SX) connected between the amplification transistor (SF) and a column line (COL).

2. The image sensor (10) of claim 1,
wherein the plurality of photodiodes include a plurality of the primary photodiodes (PD1) and a plurality of the secondary photodiodes (PD2),
wherein the plurality of primary photodiodes (PD1) are connected between the first floating diffusion node (FD1) and a reference node in parallel, and
wherein the plurality of secondary photodiodes (PD2) are connected between the second floating diffusion node (FD2) and the reference node in parallel.

3. The image sensor (10) of claim 1 or claim 2,
wherein the plurality of photodiodes further includes at least a first tertiary photodiode (PD3), and
wherein the pixel circuit includes a third floating diffusion node (FD3) connected to the first tertiary photodiode (PD3) by a first tertiary transfer transistor (TX3), and a third switch transistor (SW3) connected between the second floating diffusion node (FD2) and the third floating diffusion node (FD3).

4. The image sensor (10) of claim 3, wherein the first switch transistor (SW1) is connected between the first floating diffusion node (FD1) and the third floating diffusion node (FD3).

5. The image sensor (10) of claim 4, wherein the plurality of photodiodes include a plurality of the tertiary photodiodes (PD3), and wherein the plurality of tertiary photodiodes (PD3) are connected between the third floating diffusion node (FD3) and a reference node in parallel.

6. The image sensor (10) of any of claims 3-5, wherein the pixel circuit further includes a fourth switch transistor (SW4) connected between the first switch transistor (SW1) and the first floating diffusion node (FD1).

7. The image sensor (10) of claim 1, wherein a total number of the plurality of photodiodes in each pixel group (PG1) is four.

8. The image sensor (10) of claim 7, wherein the plurality of photodiodes in each pixel group (PG1) includes three primary photodiodes (PD1) and one secondary photodiode (PD2).

9. The image sensor (10) of claim 7, wherein the plurality of photodiodes in each pixel group includes two primary photodiodes (PD1), one secondary photodiode (PD2), and one tertiary photodiode (PD3), wherein the pixel circuit includes a third floating diffusion node (FD3) connected to the one tertiary photodiode (PD3) by a tertiary transfer transistor (TX3), and a third switch transistor (SW3) connected between the second floating diffusion node (FD2) and the third floating diffusion node (FD3).

10. The image sensor (10) of any of claims 1-6, wherein a total number of the plurality of photodiodes in each pixel group is nine.

11. The image sensor (10) of claim 10, wherein the plurality of photodiodes include eight primary photodiodes (PD1) and one secondary photodiode (PD2).

12. The image sensor (10) of claim 10, wherein the plurality of photodiodes include four primary photodiodes (PD1), one secondary photodiode (PD2), and four tertiary photodiodes (PD3), wherein the pixel circuit includes a third floating diffusion node (FD3) connected to the four tertiary photodiodes (PD3) by four tertiary transfer transistors (TX3), and a third switch transistor (SW3) connected between the second floating diffusion node (FD2) and the third floating diffusion node (FD3).

13. The image sensor (10) of claim 1,
wherein the plurality of pixel groups include a first sub-pixel group (A) and a second sub-pixel group (B), and
wherein each of the first sub-pixel group (A) and the second sub-pixel group (B) includes the plurality of photodiodes and the pixel circuit.

14. The image sensor (10) of claim 13, wherein a pixel circuit of each of the first sub-pixel group (A) and the second sub-pixel group (B) further includes a dual switch transistor (DSW), and the dual switch transistor (DSW) is connected to a node (N1) between the reset transistor and the gain control transistor (DRX), and the dual switch transistor (DSW) of each of the first sub-pixel group (A) and the second sub-pixel group (B) are connected to each other.

15. The image sensor (10) of claim 13 or claim 14, wherein each of the first sub-pixel group (A) and the second sub-pixel group (B) includes six primary photodiodes (PD1) and two secondary photodiodes (PD2).
